# EUROPEAN PATENT APPLICATION

(11) **EP 4 641 618 A1**
(43) Date of publication of application: **29.10.2025**
(21) Application number: 23911576.9
(22) Date of filing: 05.12.2023
(51) Int. Cl.: H01L 21/301, B23K 26/364, C09D 7/61, C09D 101/00, C09D 129/02, H01L 21/3065

(54) **AGENT FOR FORMING PROTECTIVE FILM, PROTECTIVE FILM, METHOD FOR PRODUCING PROTECTIVE FILM, AND METHOD FOR PRODUCING SEMICONDUCTOR CHIP**

(30) Priority: 26.12.2022 JP 2022208225
(71) Applicant: TOKYO OHKA KOGYO CO., LTD., Kawasaki-shi, Kanagawa 211 0012 (JP)
(72) Inventor: MANIWA, Hitomi, Kawasaki-shi, Kanagawa 211-0012 (JP); KINOSHITA, Tetsuro, Kawasaki-shi, Kanagawa 211-0012 (JP)
(74) Representative: Plasseraud IP
(86) International application number: PCT/JP2023/043440
(87) International publication number: WO 2024/142795

(57) **Abstract**

The purpose of the present invention is to provide: an agent for forming a protective film, the agent exhibiting excellent film formation properties when a protective film is formed therefrom, and enabling the achievement of a protective film that has excellent plasma etching resistance; a method for producing this agent for forming a protective film; a protective film which is obtained from this agent for forming a protective film; and a method for producing a semiconductor chip. The present invention provides an agent for forming a protective film, the agent containing: a first resin which does not have an aromatic ring; a metal salt which has a boiling point of 900°C or higher in cases where the metal salt is a metal fluoride; and a solvent.

## Description

### Technical Field

The present invention relates to an agent for forming a protective film, a protective film, a method for producing a protective film, and a method for producing a semiconductor chip.

### Background Art

In a wafer formed in a semiconductor device producing process, a stacked body in which an insulating film and a functional film are stacked on a surface of a semiconductor substrate such as a silicon substrate is partitioned by a grid-shaped division scheduled line called a street. By cutting the wafer along the streets, a plurality of semiconductor chips is obtained (chipping). That is, each region partitioned by the streets serves as a semiconductor chip such as an IC or an LCI.

By cutting the wafer along the streets, a plurality of semiconductor chips is obtained. For example, in an optical device wafer, a stacked body in which a gallium nitride-based compound semiconductor or the like is stacked is partitioned into a plurality of regions by streets. By cutting the optical device wafer along the streets, the optical device wafer is divided into optical devices such as light emitting diodes and laser diodes. These optical devices are widely used in electric devices.

Such cutting of a wafer is performed by, for example, plasma dicing. Plasma dicing is a processing technique in which a wafer is cut into chips by performing dry etching under vacuum or reduced pressure. In plasma dicing, for example, a Bosch process capable of deeply digging a wafer is used.

Patent Literature 1 discloses a method for dicing a substrate including a plurality of ICs, the method including: a step of forming a mask that covers and protects the ICs on the substrate, the mask including a layer of a water-soluble material in contact with upper surfaces of the ICs; a step of patterning the mask by a laser scribing process to provide a patterned mask having a gap to expose a region of the substrate between the ICs; and a step of plasma-etching the substrate through the gap in the patterned mask to divide the ICs into pieces.

### Patent Literature

Patent Literature 1: JP 2014-523112 A

### Summary of Invention

### Technical Problem

When a wafer is cut by plasma dicing, a protective film is formed on a surface of the wafer in order to protect the wafer. The protective film prevents impurities such as cutting chips and other particles generated at the time of dicing from adhering to the surface of the wafer, but there is still room for improvement in performance of the protective film.

Usually, the protective film is formed by applying an agent for forming a protective film to a wafer and forming a film. However, when a crack is generated in the protective film, impurities such as cutting chips and other particles adhere to the wafer, and the wafer is contaminated or damaged. In addition, when plasma dicing is performed on a device having a step, the thickness of the protective film cannot be sufficiently ensured at an upper portion of the step, and the film may be unintentionally thinned. For this reason, the agent for forming a protective film is required to exhibit excellent film formation properties capable of suppressing generation of a crack.

In addition, in plasma dicing, the wafer is etched using an etching gas such as a fluorine-based gas. At this time, radicals generated from such an etching gas (for example, fluorine radicals generated from a fluorine-based gas) may unnecessarily etch or damage the wafer. When such unintended etching occurs, film loss of the protective film proceeds. For this reason, the agent for forming a protective film is required to have excellent plasma etching resistance.

The present invention has been made in view of the above circumstances, and a main object of the present invention is to provide an agent for forming a protective film, the agent exhibiting excellent film formation properties when a protective film is formed therefrom, and enabling achievement of a protective film having excellent plasma etching resistance; a method for producing this agent for forming a protective film; a protective film which is obtained from this agent for forming a protective film; and a method for producing a semiconductor chip.

### Solution to Problem

As a result of intensive studies to achieve the object described above, the present inventors have found an agent for forming a protective film, the agent containing a metal salt having a boiling point of 900°C or higher in a case where the metal salt is a metal fluoride; a first resin having no aromatic ring; and a solvent, and have completed the present invention.

That is, the present invention is as follows.
<1>
   An agent for forming a protective film, the agent containing: a metal salt having a boiling point of 900°C or higher in a case where the metal salt is a metal fluoride; a first resin having no aromatic ring; and a solvent.
<2>
   The agent for forming a protective film according to <1>, further containing a second resin having an aromatic ring.
<3>
   The agent for forming a protective film according to <1> or <2>, wherein a content ratio of the metal in the metal salt is 0.15% by mass or more in a total amount of components obtained by removing the solvent from the agent for forming a protective film.
<4>
   The agent for forming a protective film according to any one of <1> to <3>, wherein the metal of the metal salt contains at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce.
<5>
   The agent for forming a protective film according to any one of <1> to <4>, wherein the metal salt contains at least one selected from the group consisting of a sulfate, a nitrate, a nitrite, and hydrates of these salts.
<6>
   The agent for forming a protective film according to any one of <1> to <5>, wherein the first resin contains at least one selected from the group consisting of a cellulose-based resin and a vinyl-based resin.
<7>
   The agent for forming a protective film according to any one of <1> to <6>, wherein the first resin contains at least one selected from the group consisting of a resin (1A) containing a repeating unit represented by the following formula (1a), a resin (1B) containing a repeating unit represented by the following formula (1b-1) and a repeating unit represented by the following formula (1b-2), a resin (1C) containing a repeating unit represented by the following formula (1c), and a resin (1D) containing a repeating unit represented by the following formula (1d). 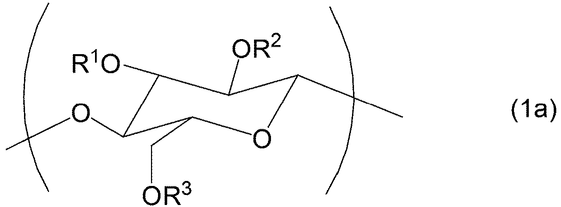 (In the formula, R¹, R², and R³ are each independently a substituent represented by -H, -CH₃, - CH₂CH₃, or -CH₂CH(OH)CH₃, and at least one of all R¹s, R²s, and R³s is a substituent other than -H.) 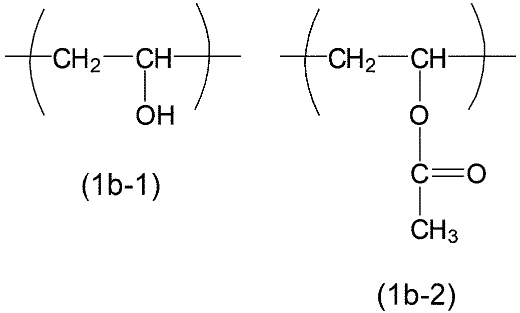 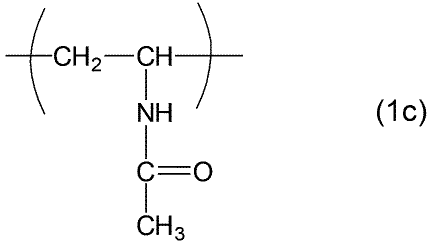 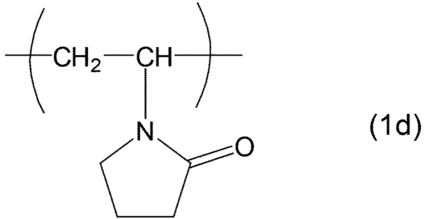
<8>
   The agent for forming a protective film according to any one of <2> to <7>, wherein the second resin contains at least one selected from the group consisting of a resin (2A) containing a repeating unit represented by the following formula (2a-1) and a repeating unit represented by the following formula (2a-2), a resin (2B) containing a repeating unit represented by the following formula (2b-1) and a repeating unit represented by the following formula (2b-2), and a resin (2C) containing a repeating unit represented by the following formula (2c). 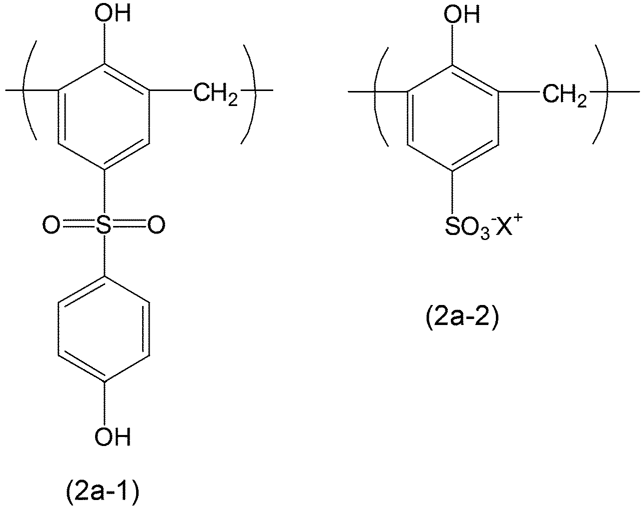 (In the formula, X⁺ is an alkali metal cation, a proton, or N⁺R⁴₄, and R⁴ is a hydrogen atom, an alkyl group, or a hydroxyalkyl group.) 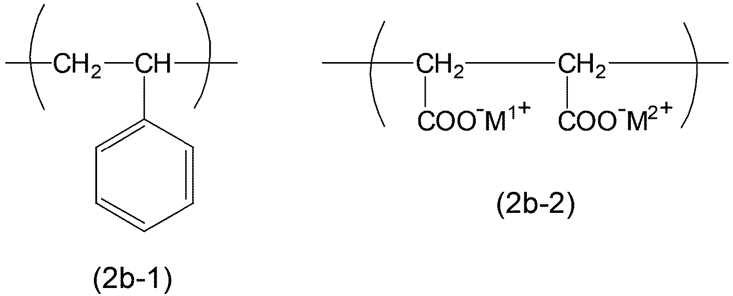 (In the formula, M¹⁺ and M²⁺ are each independently an alkali metal cation, a proton, or N⁺R⁵₄, and R⁵ is a hydrogen atom, an alkyl group, or a hydroxyalkyl group.) 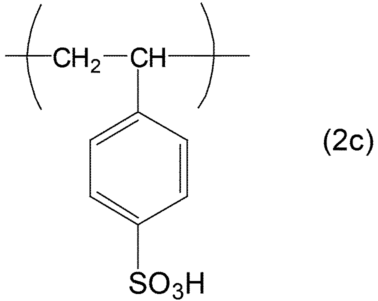
<9>
   A protective film containing: a metal salt having a boiling point of 900°C or higher in a case where the metal salt is a metal fluoride; and a first resin having no aromatic ring.
<10>
   The protective film according to <9>, further containing a second resin having an aromatic ring.
<11>
   The protective film according to <9> or <10>, wherein a content ratio of the metal in the metal salt is 0.15% by mass or more in the protective film.
<12>
   The protective film according to any one of <9> to <11>, wherein a metal of the metal salt contains at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce.
<13>
   The protective film according to any one of <9> to <12>, having a film thickness of 0.1 µm or more and 100 µm or less.
<14>
   A method for producing a protective film, the method including a step of applying the agent for forming a protective film according to any one of <1> to <7> onto a substrate to form a protective film.
<15>
   A method for producing a semiconductor chip by cutting a semiconductor wafer by plasma dicing, the method including: a step of applying the agent for forming a protective film according to any one of <1> to <7> onto a semiconductor wafer to form a protective film; a step of irradiating a predetermined position of one or more layers including the protective film on the semiconductor wafer with a laser beam to expose a surface of the semiconductor wafer and form a processed groove having a pattern corresponding to the shape of the semiconductor chip; and a step of irradiating the semiconductor wafer on which the processed groove is formed with plasma to cut a position of the processed groove of the semiconductor wafer to obtain a semiconductor chip.

### Advantageous Effects of Invention

According to the present invention, it is possible to provide: an agent for forming a protective film, the agent exhibiting excellent film formation properties when a protective film is formed therefrom, and enabling achievement of a protective film having excellent plasma etching resistance; a method for producing this agent for forming a protective film; a protective film obtained from this agent for forming a protective film; and a method for producing a semiconductor chip.

### Description of Embodiments

Hereinafter, modes for carrying out the present invention (hereinafter, simply referred to as "the present embodiment") will be described in detail. The following present embodiment is an example for describing the present invention, and is not intended to limit the present invention to the following contents. The present invention can be appropriately modified and implemented within the scope of the gist thereof.

### <Agent for forming a protective film>

An agent for forming a protective film according to the present embodiment contains: a metal salt having a boiling point of 900°C or higher in a case where the metal salt is a metal fluoride; a first resin having no aromatic ring; and a solvent. The agent for forming a protective film can be used, for example, to form a protective film on a surface of a semiconductor wafer when the semiconductor wafer is diced. As a result of intensive studies, the present inventors have unexpectedly found that by using a resin having no aromatic ring and a metal salt having a boiling point of 900°C or higher in a case where the metal salt is a metal fluoride in combination, film formation properties when a protective film is formed from the agent are excellent, and a protective film having excellent plasma etching resistance can be obtained.

### (Metal salt and metal)

The agent for forming a protective film according to the present embodiment contains a metal salt having a boiling point of 900°C or higher in a case where the metal salt is a metal fluoride.

The kind of metal (metal kind) of the metal salt is not particularly limited as long as it is a metal having a boiling point of 900°C or higher in a case where the metal salt is a metal fluoride. The metal of the metal salt preferably contains at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce from a viewpoint of being able to further improve film formation properties and plasma etching resistance.

Here, as an example, the boiling points of fluorides of metals are presented in the following Table. Note that the phrase "having a boiling point of 900°C or higher in a case where the metal salt is a metal fluoride" means that at least one kind of fluoride that can be taken by the metal only may be 900°C or higher. For example, in a case of Ag, a plurality of fluorides such as Ag₂F, AgF, AgF₂, and AgF₃ are conceivable, but at least one of these (for example, AgF) only may have a boiling point of 900°C or higher.

**[Table 1]**

| | | | |
|---|---|---|---|
| Fluoride of Li | | Fluoride of Ga | |
| (lithium fluoride, LiF) | 1671°C | (gallium fluoride, GaF₂) | 1000°C |
| Fluoride of Be | | Fluoride of Rb | |
| (beryllium fluoride, BeF₂) | 1169°C | (rubidium fluoride, RbF) | 1408°C |
| Fluoride of Na | | Fluoride of Sr | |
| (sodium fluoride, NaF) | 1704°C | (strontium fluoride, SrF) | 2460°C |
| Fluoride of Mg | | Fluoride of Y | |
| (magnesium fluoride, MgF₂) | 2260°C | (yttrium fluoride, YF₂) | 2230°C |
| Fluoride of Al | | Fluoride of Zr | |
| (aluminum fluoride, AlF₂) | 1260°C | (zirconium tetrafluoride, ZrF₄) | 905°C |
| Fluoride of K | | Fluoride of Ag | |
| (potassium fluoride, KF) | | (disilver monofluoride, Ag₂F) | -°C |
| | | | 1159°C |
| | 1505°C | (silver(I) fluoride, AgF) | -°C |
| | | (silver(II) fluoride, AgF₂) | -°C |
| | | (silver(III) fluoride, AgF₃) | |
| Fluoride of Ca | | Fluoride of Cd | |
| (calcium fluoride, CaF₂) | 2533°C | (cadmium fluoride, CdF₂) | 1748°C |
| Fluoride of Mn | | Fluoride of In | |
| (manganese fluoride, MnF₂) | 1820°C | (indium fluoride, InF₃) | 1200°C < |
| Fluoride of Fe | | Fluoride of Cs | |
| (iron (II) fluoride, FeF₂) | 1100°C | (cesium fluoride, CsF) | 1251°C |
| (Iron (III) fluoride, FeF₃) | -°C | | |
| Fluoride of Co | | Fluoride of Ba | |
| (cobalt (II) fluoride, CoF₂) | 1400°C | (barium fluoride, BaF₂) | 2260°C |
| (cobalt (III) fluoride, CoF₃) | -°C | | |
| Fluoride of Ni | | Fluoride of La | |
| (nickel fluoride, NiF₂) | 1750°C | (lanthanum fluoride, LaF₃) | 2300°C |
| Fluoride of Cu | | Fuoride of Ce | |
| (copper (II) fluoride, CuF₂) | 1676°C | (cerium fluoride, CeF₃) | 1360°C |
| (copper (I) fluoride, CuF) | -°C | | |
| Fluoride of Zn | | | |
| (zinc fluoride, ZeF₂) | 1500°C | | |

A content ratio of a metal having a boiling point of 900°C or higher in a case where the metal salt is a metal fluoride is not particularly limited, but a content ratio of the metal of the metal salt in the total amount of components obtained by removing a solvent from the agent for forming a protective film ((metal of metal salt)/(total amount of components obtained by removing a solvent from the agent for forming a protective film)) is preferably 0.15% by mass or more from a viewpoint of being able to further increase a selection ratio while having excellent film formation properties. A lower limit of the content ratio is more preferably 1.0% by mass or more, and still more preferably 1.5% by mass or more. An upper limit of the content ratio is preferably 3.5% by mass or less, more preferably 3.0% by mass or less, and still more preferably 2.5% by mass or less.

The agent for forming a protective film according to the present embodiment may contain, as the metal salt, not only a salt of a metal having a boiling point of 900°C or higher in a case where the metal salt is a metal fluoride but also a salt of a metal having a boiling point of lower than 900°C in a case where the metal salt is a metal fluoride. However, the agent for forming a protective film according to the present embodiment preferably contains, as the metal salt, only a salt of a metal having a boiling point of 900°C or higher in a case where the metal salt is a metal fluoride from a viewpoint of achieving both film formation properties and plasma etching resistance at a higher level. That is, the metal of the metal salt contained in the agent for forming a protective film is preferably only a metal having a boiling point of 900°C or higher in a case where the metal salt is a metal fluoride.

In addition, the agent for forming a protective film according to the present embodiment preferably does not substantially contain a salt (metal salt) of a metal other than Li, Be, Na, Mg, Al, K, Ca, Mn, Fe, Co, Ni, Cu, Zn, Ga, Rb, Sr, Y, Zr, Ag, Cd, In, Cs, Ba, La, and Ce from a viewpoint of achieving both film formation properties and plasma etching resistance at a higher level. Furthermore, a content ratio of a salt (metal salt) of a metal other than Li, Be, Na, Mg, Al, K, Ca, Mn, Fe, Co, Ni, Cu, Zn, Ga, Rb, Sr, Y, Zr, Ag, Cd, In, Cs, Ba, La, and Ce is more preferably 0% by mass. Note that, in the present specification, "not substantially contain" means that the component is not actively added or mixed, and does not exclude that the component is inevitably contained or mixed.

In addition, the kind of the salt of the metal salt contained in the agent for forming a protective film according to the present embodiment is not particularly limited. As the kind of the salt of the metal salt, at least one selected from the group consisting of a sulfate, a nitrate, a nitrite, and hydrates of these salts is preferably contained. Since these salts tend to have high water solubility, compatibility with other components in the agent for forming a protective film is further enhanced, and film formation properties can be further improved.

The agent for forming a protective film according to the present embodiment may contain, as the metal salt, not only a sulfate, a nitrate, a nitrite, and hydrates thereof but also a metal salt other than these, or does not have to contain, as the metal salt, a metal salt other than a sulfate, a nitrate, a nitrite, and hydrates thereof.

In the agent for forming a protective film according to the present embodiment, the content of the metal salt is not particularly limited, but the total content of the metal salt is preferably 15.0 parts by mass or less, more preferably 9.4 parts by mass or less, still more preferably 9.3 parts by mass or less, and further still more preferably 9.0 parts by mass or less with respect to 100 parts by mass of a solid content in the agent for forming a protective film. In addition, the total content of the metal salt is preferably 0.15 parts by mass or more, more preferably 0.3 parts by mass or more, and still more preferably 0.4 parts by mass or more with respect to 100 parts by mass of a solid content in the agent for forming a protective film.

### (First resin)

The first resin is a resin having no aromatic ring (also referred to as a "non-aromatic resin"). The first resin is preferably water-soluble (also referred to as a "water-soluble resin"). When the first resin is water-soluble, a protective film can be effectively formed by dissolving the first resin in a solvent such as water or an aqueous medium and applying and drying the solution. In addition, a protective film can be easily removed by water washing after plasma etching processing. Note that, in the present specification, "water-soluble" means that 0.5 g or more of a solute (the resin) is dissolved in 100 g of water at 25°C.

In this regard, conventionally, there is a problem that a crack is likely to be generated when a protective film is formed using a water-soluble material. In particular, when the protective film is thick, a crack tends to be easily generated. In addition, use of a water-soluble material tends to reduce plasma etching resistance. However, according to the present embodiment, unexpectedly, occurrence of such a problem can be effectively suppressed by using the above-described metal salt and the first resin in combination.

Note that the water-soluble resin also includes a resin solubilized in water by a hydrolysis reaction or a treatment with a base in an aqueous medium. For example, a resin in which 0.5 g or more of a solute (the resin) can be dissolved in 100 g of water at 25°C as a result of such a reaction or treatment also corresponds to the "water-soluble resin" in the present specification.

The first resin preferably contains at least one selected from the group consisting of a cellulose-based resin, a vinyl-based resin, a polyalkylene oxide (for example, a polyethylene oxide such as polyethylene glycol or a polypropylene oxide such as polypropylene glycol), a polyglycerin, and a water-soluble nylon, and more preferably contains at least one selected from the group consisting of a cellulose-based resin and a vinyl-based resin. These resins are preferably water-soluble.

A weight average molecular weight of the first resin is not particularly limited, but is usually preferably 100 or more and 300,000 or less. A lower limit of the weight average molecular weight is more preferably 1000 or more, and still more preferably 10,000 or more. An upper limit of the weight average molecular weight is more preferably 200,000 or less, and still more preferably 150,000 or less.

Note that, unless otherwise specified, a weight average molecular weight in the present specification refers to a weight average molecular weight (M_{w}) in terms of polystyrene, obtained by gel permeation chromatography (GPC) analysis.

The cellulose-based resin is cellulose or a cellulose derivative, and preferably has water solubility. Examples of the cellulose derivative may include those obtained by modifying cellulose with an alkyl group (a methyl group, an ethyl group, or the like) and those obtained by modifying cellulose with a hydroxyalkyl group (for example, a hydroxymethyl group, a hydroxyethyl group, or a hydroxypropyl group). Specific examples of the cellulose derivative may include at least one selected from the group consisting of methyl cellulose, ethyl cellulose, hydroxymethyl cellulose, hydroxyethyl cellulose, and hydroxypropyl cellulose.

A weight average molecular weight of the cellulose-based resin is not particularly limited, but is preferably 1000 or more and 300,000 or less. A lower limit of the weight average molecular weight is more preferably 10,000 or more. An upper limit of the weight average molecular weight is more preferably 200,000 or less, and still more preferably 150,000 or less.

The vinyl-based resin is preferably a water-soluble resin that is a homopolymer of a monomer having a vinyl group or a copolymer of a monomer having a vinyl group. Specific examples of the vinyl-based resin may include at least one selected from the group consisting of a polyvinyl alcohol-based resin, poly-N-vinylacetamide, polyvinylpyrrolidone, polyacrylamide, poly(N-alkylacrylamide), polyallylamine, poly(N-alkylallylamine), partially amidated polyallylamine, poly(diallylamine), an allylamine-diallylamine copolymer, and polyacrylic acid.

Specific examples of the polyvinyl alcohol-based resin may include polyvinyl alcohol, polyvinyl acetal (including a vinyl acetate copolymer), a butenediol-vinyl alcohol copolymer, a polyvinyl alcohol polyacrylic acid block copolymer, and a polyvinyl alcohol polyacrylate block copolymer. Among these resins, polyvinyl alcohol is preferable.

A protective film formed on a surface of a semiconductor wafer is usually removed from the surface of the semiconductor wafer or a semiconductor chip by water washing at an appropriate time after formation of a processed groove. Therefore, a water-soluble resin having high affinity with water is preferable from a viewpoint of water washability of the protective film. Among the resins described above, the water-soluble resin having high affinity with water is preferably a resin having only a hydroxy group, an amide bond, and/or an ether bond as a polar group, for example, hydroxypropyl cellulose, polyvinyl alcohol, poly-N-vinylacetamide, polyvinyl pyrrolidone, or polyethylene glycol.

Furthermore, a cellulose-based resin and a vinyl-based resin are preferable, and hydroxypropylcellulose, polyvinyl alcohol, poly-N-vinylacetamide, polyvinylpyrrolidone, and the like are more preferable from a viewpoint that deterioration of the shape of the processed groove due to heat sagging of the protective film and the like can be more effectively suppressed.

These resins may be used singly or in combination of two or more kinds thereof.

A more specific preferable example of the first resin will be described. The first resin preferably contains at least one selected from the group consisting of a resin (1A) containing a repeating unit represented by the following formula (1a), a resin (1B) containing a repeating unit represented by the following formula (1b-1) and a repeating unit represented by the following formula (1b-2), a resin (1C) containing a repeating unit represented by the following formula (1c), and a resin (1D) containing a repeating unit represented by the following formula (1d).

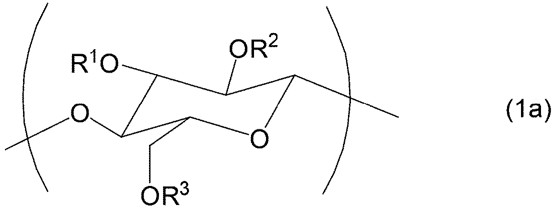

(In the formula, R¹, R², and R³ are each independently a substituent represented by -H, -CH₃, - CH₂CH₃, or -CH₂CH(OH)CH₃, and at least one of all R¹s, R²s, and R³s is a substituent other than -H.)

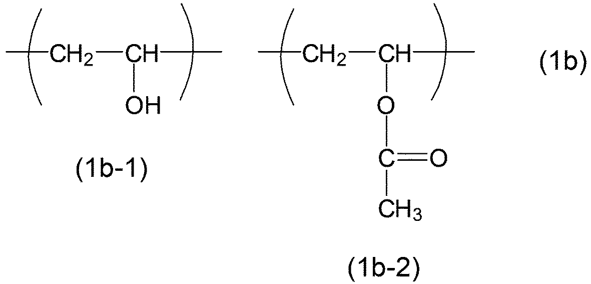

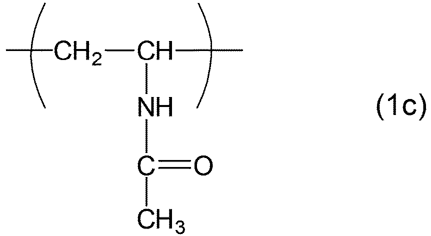

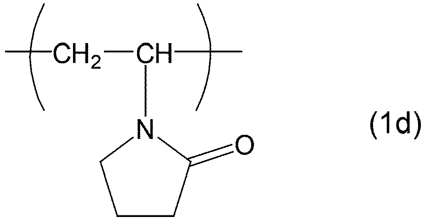

The resin (1A) may be a resin containing a repeating unit represented by formula (1a), and may also contain another repeating unit. The resin (1A) is preferably a resin containing only a repeating unit represented by formula (1a) from a viewpoint of film formation properties of a protective film, plasma etching resistance, water washability, accuracy of the shape of a processed groove, and the like. Specific examples of the resin (1A) may include a cellulose derivative. Preferable examples of the resin (1A) may include the methyl cellulose and the ethyl cellulose described above, and propylene cellulose.

R¹, R², and R³ in formula (1a) only need to be each independently a substituent represented by -H, -CH₃, - CH₂CH₃, or -CH₂CH(OH)CH₃, but preferably, R¹, R², and R³ in formula (1a) are each independently a substituent represented by -H or -CH₂CH(OH)CH₃, and at least one of all R¹s, R²s, and R³s is -CH₂CH(OH)CH₃.

A weight average molecular weight of the resin (1A) is not particularly limited, but is preferably 10,000 or more and 300,000 or less. A lower limit of the weight average molecular weight is more preferably 15000 or more, and still more preferably 20,000 or more. An upper limit of the weight average molecular weight is more preferably 200,000 or less, still more preferably 100,000 or less, and still more preferably 50,000 or less.

The resin (1B) may be a resin containing a repeating unit represented by formula (1b-1) and a repeating unit represented by formula (1b-2) (see formula (1b)), and may also contain another repeating unit. The resin (1B) is preferably a resin containing only a repeating unit represented by formula (1b-1) and a repeating unit represented by formula (1b-2) (see formula (1b)) from a viewpoint of film formation properties of a protective film, plasma etching resistance, water washability, accuracy of the shape of a processed groove, and the like.

Water solubility of the resin (1B) can be improved, for example, by adjusting the content of the repeating unit represented by formula (1b-1), the content of the repeating unit represented by formula (1b-2), a molar ratio between the repeating unit represented by formula (1b-1) and the repeating unit represented by formula (1b-2), and the like.

The ratio between the repeating unit represented by formula (1b-1) and the repeating unit represented by formula (1b-2) is not particularly limited, but from the above-described viewpoint, an upper limit of a molar ratio of the repeating unit represented by formula (1b-1) to the total of the repeating unit represented by formula (1b-1) and the repeating unit represented by formula (1b-2) (formula (1b-1)/(formula (1b-1) + formula (1b-2)) is preferably 0.965 or less, and more preferably 0.890 or less. A lower limit of the molar ratio is not particularly limited, but is preferably 0.500 or more, and more preferably 0.695 or more.

Preferable examples of the resin (1B) may include the polyvinyl alcohol described above. The polyvinyl alcohol can be obtained, for example, by saponifying polyvinyl acetate obtained by polymerizing a vinyl acetate monomer. In this case, as represented by formula (1b), a resin having both the repeating unit represented by formula (1b-1) and the repeating unit represented by formula (1b-2) can be obtained.

A polymerization degree of the resin (1B) is not particularly limited, but is preferably 300 or more and 2500 or less. A lower limit of the polymerization degree is more preferably 500 or more. An upper limit of the polymerization degree is more preferably 2000 or less.

The resin (1C) may be a resin containing a repeating unit represented by formula (1c), and may also contain another repeating unit. The resin (1C) is preferably a resin containing only a repeating unit represented by formula (1c) from a viewpoint of film formation properties of a protective film, plasma etching resistance, water washability, accuracy of the shape of a processed groove, and the like. Preferable examples of the resin (1C) may include the N-vinylacetamide described above.

A weight average molecular weight of the resin (1C) is not particularly limited, but is preferably 200,000 or more and 1,500,000 or less. A lower limit of the weight average molecular weight is more preferably 250,000 or more, and still more preferably 500,000 or more. An upper limit of the weight average molecular weight is more preferably 1,000,000 or less from a viewpoint of film formation properties and the like.

The resin (1D) may be a resin containing a repeating unit represented by formula (1d), and may also contain another repeating unit. The resin (1D) is preferably a resin containing only a repeating unit represented by formula (1d) from a viewpoint of film formation properties of a protective film, plasma etching resistance, water washability, accuracy of the shape of a processed groove, and the like. Preferable examples of the resin (1D) may include the polyvinylpyrrolidone described above.

A weight average molecular weight of the resin (1D) is not particularly limited, but is preferably 10,000 or more and 1,500,000 or less. A lower limit of the weight average molecular weight is more preferably 40,000 or more, still more preferably 50,000 or more, and further still more preferably 100,000 or more. An upper limit of the weight average molecular weight is more preferably 1,200,000 or less.

### (Second resin)

The second resin is a resin having an aromatic ring (also referred to as an "aromatic resin"). Examples of an aromatic ring having a monocyclic structure may include a benzene ring. Examples of an aromatic ring having a polycyclic structure may include a naphthalene ring, a biphenyl ring, an anthracene ring, and a phenanthrene ring.

The second resin is preferably water-soluble. When the second resin is a water-soluble resin, the second resin is more preferably a water-soluble resin having an aromatic ring and a water-soluble group. The water-soluble resin referred to herein also includes a resin solubilized in water by a hydrolysis reaction or a treatment with a base in an aqueous medium as described above. Examples of the water-soluble group may include -SO₃⁻A⁺ (A⁺ is an alkali metal cation, a proton, or N⁺R₄. R is a hydrogen atom, an alkyl group, or a hydroxyalkyl group.), -COO⁻A⁺ (A⁺ is an alkali metal cation, a proton, or N⁺R₄. R is a hydrogen atom, an alkyl group, or a hydroxyalkyl group.), a carboxylic acid anhydride group (-CO-O-CO-), a hydroxy group, and an ether bond (-O-).

Note that examples of the alkali metal cation may include a sodium cation (Na⁺), a potassium cation (K⁺), and a strontium cation (Sr⁺). Examples of the alkyl group may include a methyl group, an ethyl group, and a propyl group (for example, a n-propyl group or an isopropyl group). Examples of the hydroxyalkyl group may include a hydroxymethyl group, a hydroxyethyl group, and a hydroxypropyl group. The carboxylic acid anhydride group (-CO-O-CO-) is a group that gives -COO⁻X⁺ by hydrolysis or a treatment with a base in water.

Examples of the second resin may include a resin containing a styrene-based unit and a resin containing a phenol-based unit. Examples of the styrene-based unit may include styrene and a structural unit derived from a styrene derivative having a substituent on an α-position or a benzene ring. Examples of the phenol-based unit may include a resin containing a phenolic hydroxy group.

The resin having a phenolic hydroxy group may be water-soluble or hardly soluble in water (water-insoluble) depending on a structure thereof. When the resin having a phenolic hydroxy group is hardly soluble in water, the resin may be solubilized in water by treating the resin in a basic aqueous medium to convert the phenolic hydroxy group into a salt.

A weight average molecular weight of the second resin is not particularly limited, but is usually preferably 100 or more and 300,000 or less. A lower limit of the weight average molecular weight is more preferably 1000 or more, and still more preferably 10,000 or more. An upper limit of the weight average molecular weight is more preferably 200,000 or less, and still more preferably 150,000 or less.

A more specific preferable example of the second resin will be described. The second resin preferably contains at least one selected from the group consisting of a resin (2A) containing a repeating unit represented by the following formula (2a-1) and a repeating unit represented by the following formula (2a-2), a resin (2B) containing a repeating unit represented by the following formula (2b-1) and a repeating unit represented by the following formula (2b-2), and a resin (2C) containing a repeating unit represented by the following formula (2c). By using these resins in combination with the metal salt and the first resin described above, at least film formation properties and plasma etching resistance can be further improved.

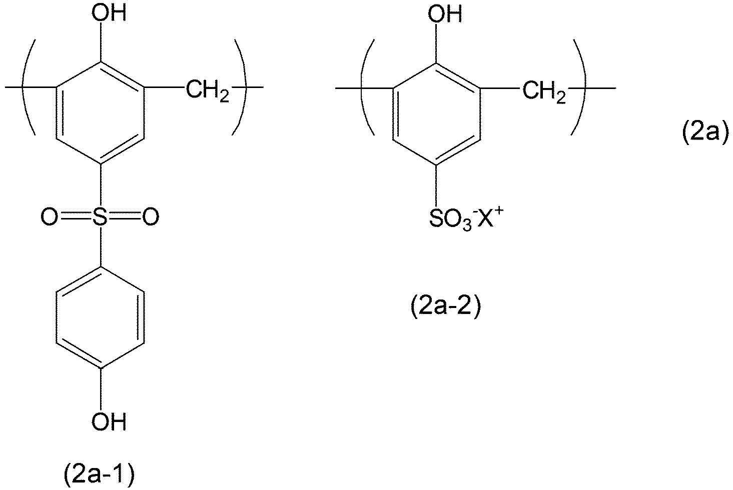

(In the formula, X⁺ is an alkali metal cation, a proton, or N⁺R⁴₄, and R⁴ is a hydrogen atom, an alkyl group, or a hydroxyalkyl group.)

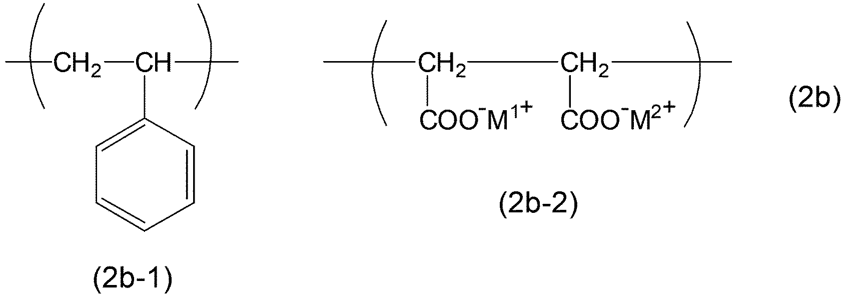

(In the formula, M¹⁺ and M²⁺ are each independently an alkali metal cation, a proton, or N⁺R⁵₄, and R⁵ is a hydrogen atom, an alkyl group, or a hydroxyalkyl group.)

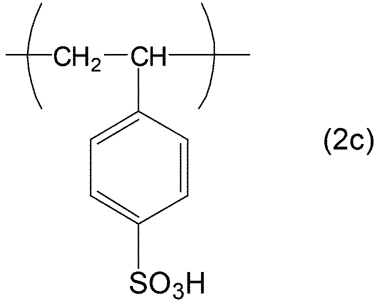

The resin (2A) may be a resin containing a repeating unit represented by formula (2a-1) and a repeating unit represented by formula (2a-2) (see formula (2a)), and may also contain another repeating unit. The resin (2A) is preferably a resin containing only a repeating unit represented by formula (2a-1) and a repeating unit represented by formula (2a-2) (see formula (2a)) from a viewpoint of film formation properties of a protective film, plasma etching resistance, water washability, accuracy of the shape of a processed groove, and the like.

(In formula (2a-2), X⁺ is an alkali metal cation, a proton, or N⁺R⁴₄, and R⁴ may be a hydrogen atom, an alkyl group, or a hydroxyalkyl group.) Examples of the alkali metal cation may include a sodium cation (Na⁺), a potassium cation (K⁺), and a strontium cation (Sr⁺). Examples of the alkyl group may include a methyl group, an ethyl group, and a propyl group (for example, a n-propyl group or an isopropyl group). Examples of the hydroxyalkyl group may include a hydroxymethyl group, a hydroxyethyl group, and a hydroxypropyl group.

Among the above examples, X⁺ is preferably N⁺R⁴₄, and R⁴ is more preferably a hydrogen atom. As a specific example of X⁺, for example, X⁺ is preferably NH₄⁺.

Water solubility of the resin (2A) can be improved, for example, by increasing the content of a repeating unit represented by formula (2a-2) having high hydrophilicity.

A ratio between the repeating unit represented by formula (2a-1) and the repeating unit represented by formula (2a-2) is not particularly limited, but from the above-described viewpoint, a molar ratio of the repeating unit represented by formula (2a-1) to the repeating unit represented by formula (2a-2) (formula (2a-1)/(formula (2a-2)) is preferably 0.1 or more and 9 or less from a viewpoint of easiness of imparting water solubility. A lower limit of the molar ratio is more preferably 0.25 or more. An upper limit of the molar ratio is more preferably 7 or less, and still more preferably 4 or less.

Preferable examples of the resin (2A) may include a resin in which X⁺ in formula (2a-2) is NH₄⁺. This resin can be obtained, for example, by demetallizing a copolymer containing a dihydroxydiphenylsulfone-type repeating unit (see formula (2a-1)) and a phenol-type sodium sulfonate repeating unit (see a case where X⁺ in formula (2a-2) is Na⁺) by a hydrochloric acid treatment and then diluting the copolymer with aqueous ammonia.

A weight average molecular weight of the resin (2A) is not particularly limited, but is preferably 5,000 or more and 300,000 or less. A lower limit of the weight average molecular weight is more preferably 10,000 or more, still more preferably 15,000 or more, and further still more preferably 20,000 or more. An upper limit of the weight average molecular weight is more preferably 200,000 or less, still more preferably 100,000 or less, further still more preferably 50,000 or less, and further still more preferably 25,000 or less.

The resin (2B) may be a resin containing a repeating unit represented by formula (2b-1) and a repeating unit represented by formula (2b-2) (see formula (2b)), and may also contain another repeating unit. The resin (2B) is preferably a resin containing only a repeating unit represented by formula (2b-1) and a repeating unit represented by formula (2b-2) (see formula (2b)) from a viewpoint of film formation properties of a protective film, plasma etching resistance, water washability, accuracy of the shape of a processed groove, and the like.

In formula (2b-2), M¹⁺ and M²⁺ are, for example, monovalent cations, are each independently an alkali metal cation, a proton, or N⁺R⁵₄, and R⁵ may be a hydrogen atom, an alkyl group, or a hydroxyalkyl group. Examples of the alkali metal cation may include a sodium cation (Na⁺), a potassium cation (K⁺), and a strontium cation (Sr⁺). Examples of the alkyl group may include a methyl group, an ethyl group, and a propyl group (for example, a n-propyl group or an isopropyl group). Examples of the hydroxyalkyl group may include a hydroxymethyl group, a hydroxyethyl group, and a hydroxypropyl group.

Among the above examples, at least one of M¹⁺ and M²⁺ is preferably N⁺R⁵₄, and R⁵ is more preferably a hydrogen atom. In addition, M¹⁺ and M²⁺ are more preferably the same. As a specific example of M¹⁺ and M²⁺, at least one of M¹⁺ and M²⁺ is preferably NH₄⁺, and each of M¹⁺ and M²⁺ is preferably NH₄⁺ (Both of M¹⁺ and M²⁺ are preferably NH₄⁺, respectively.).

Water solubility of the resin (2B) can be improved, for example, by increasing the content of a repeating unit represented by formula (2b-2) having high hydrophilicity.

A ratio between the repeating unit represented by formula (2b-1) and the repeating unit represented by formula (2b-2) is not particularly limited, but from the above-described viewpoint, a molar ratio of the repeating unit represented by formula (2b-1) to the repeating unit represented by formula (2b-2) (formula (2b-1)/(formula (2b-2)) is preferably 1 or more and 8 or less from a viewpoint of easiness of imparting water solubility. A lower limit of the molar ratio is more preferably 2 or more. An upper limit of the molar ratio is more preferably 6 or less, still more preferably 5 or less, and further still more preferably 4 or less.

Preferable examples of the resin (2B) may include a resin in which each of M¹⁺ and M²⁺ in formula (2b-2) is NH₄⁺ as described above. This resin can be obtained, for example, by diluting a styrene-maleic anhydride copolymer with aqueous ammonia.

A weight average molecular weight of the resin (2B) is not particularly limited, but is preferably 5,000 or more and 200,000 or less. A lower limit of the weight average molecular weight is more preferably 7,000 or more, and still more preferably 8,000 or more. An upper limit of the weight average molecular weight is more preferably 100,000 or less, still more preferably 50,000 or less, further still more preferably 40,000 or less, and further still more preferably 30,000 or less.

The resin (2C) may be a resin containing a repeating unit represented by formula (2c), and may also contain another repeating unit. The resin (2C) is preferably a resin containing only a repeating unit represented by formula (2c) from a viewpoint of film formation properties of a protective film, plasma etching resistance, water washability, accuracy of the shape of a processed groove, and the like. Preferable examples of the resin (2C) may include polystyrene sulfonic acid.

A weight average molecular weight of the resin (2C) is not particularly limited, but is preferably 5,000 or more and 1,200,000 or less. A lower limit of the weight average molecular weight is more preferably 10,000 or more, still more preferably 15,000 or more, and further still more preferably 20,000 or more. An upper limit of the weight average molecular weight is more preferably 500,000 or less, still more preferably 300,000 or less, further still more preferably 100,000 or less, further still more preferably 50000 or less, and further still more preferably 30,000 or less.

Note that the agent for forming a protective film according to the present embodiment preferably contains only a water-soluble resin as a resin. In this case, the agent for forming a protective film according to the present embodiment may further contain a resin other than the first resin and the second resin described above. For example, when the agent for forming a protective film according to the present embodiment contains only the first resin as a resin, the first resin is preferably a water-soluble resin. When the agent for forming a protective film according to the present embodiment contains only the first resin and the second resin as resins, the first resin and the second resin are preferably water-soluble resins. When the agent for forming a protective film according to the present embodiment contains, as resins, the first resin, the second resin, and a resin other than the first resin and the second resin, all of the first resin, the second resin, and the other resin are preferably water-soluble resins.

In the agent for forming a protective film according to the present embodiment, a content ratio of the first resin and the second resin is not particularly limited, but the total content of the first resin and the second resin with respect to 100 parts by mass of a solid content in the agent for forming a protective film is preferably 99.8 parts by mass or less, and more preferably 99.6 parts by mass or less. In addition, the total content of the first resin and the second resin with respect to 100 parts by mass of a solid content in the agent for forming a protective film is preferably 80.0 parts by mass or more, and more preferably 90.0 parts by mass or more.

### (Additive and the like)

The agent for forming a protective film according to the present embodiment may contain another additive as necessary. Examples of the other additive may include a light-absorbing agent, a basic compound, a dye, a pigment, a plasticizer, a preservative, and a surfactant.

### (Light-absorbing agent)

As the light-absorbing agent, a light-absorbing agent generally used for an agent for forming a protective film can be used. Examples of the light-absorbing agent may include organic acids having a carboxy group and/or a sulfo group; sodium salts, potassium salts, ammonium salts, and quaternary ammonium salts of these organic acids; and a compound having a hydroxy group.

Specific examples of the light-absorbing agent may include a benzophenone-based compound, a cinnamic acid-based compound, an anthraquinone-based compound, a naphthalene-based compound, a biphenyl-based compound, and water-soluble amines.

Specific examples of the benzophenone-based compound may include benzophenone, 4,4'-dicarboxybenzophenone, benzophenone-4-carboxylic acid, tetrahydroxybenzophenone, 2-(4-diethylamino-2-hydroxybenzoyl) benzoic acid (DHBA), and EAB-F(4,4'-bis(diethylamino) benzophenone).

Specific examples of the cinnamic acid-based compound may include cinnamic acid, 4-aminocinnamic acid, 3-aminocinnamic acid, 2-aminocinnamic acid, sinapic acid (3,5-dimethoxy-4-hydroxycinnamic acid), ferulic acid, and caffeic acid. Among these examples, 4-aminocinnamic acid, 3-aminocinnamic acid, 2-aminocinnamic acid, and ferulic acid are preferable, 4-aminocinnamic acid and ferulic acid are more preferable, and 4-aminocinnamic acid is still more preferable.

Specific examples of the anthraquinone-based compound may include anthraquinone, 2-carboxyanthraquinone, 2,6-anthraquinone disulfonic acid, and 2,7-anthraquinone disulfonic acid.

Specific examples of the naphthalene-based compound may include naphthalene, 1,2-naphthalene dicarboxylic acid, 1,8-naphthalene dicarboxylic acid, 2,3-naphthalene dicarboxylic acid, 2,6-naphthalene dicarboxylic acid, and 2,7-naphthalene dicarboxylic acid.

Specific examples of the biphenyl-based compound may include biphenyl and biphenyl-4-sulfonic acid.

Specific examples of the water-soluble amines may include curcumin.

Among the above examples, a benzophenone-based compound, a cinnamic acid-based compound, and the like are preferable, and tetrahydroxybenzophenone, 2-(4-diethylamino-2-hydroxybenzoyl) benzoic acid (DHBA), 4-aminocinnamic acid, and the like are more preferable.

A content ratio of the light-absorbing agent in the agent for forming a protective film according to the present embodiment is not particularly limited as long as the object of the present embodiment is not impaired, but the content of the light-absorbing agent with respect to 100 parts by mass of a solid content in the agent for forming a protective film is preferably 1 part by mass or more and 10 parts by mass or less. A lower limit of the content of the light-absorbing agent with respect to 100 parts by mass of a solid content in the agent for forming a protective film is more preferably 1.5 parts by mass or more. An upper limit of the content of the light-absorbing agent with respect to 100 parts by mass of a solid content in the agent for forming a protective film is more preferably 7 parts by mass or less, still more preferably 5 parts by mass or less, and further still more preferably 3 parts by mass or less.

### (Basic compound)

The agent for forming a protective film according to the present embodiment may contain a basic compound for the purpose of more easily dissolving a solid content. As the basic compound, either an inorganic compound or an organic compound can be used. As the basic compound, an organic compound is preferable.

Specific examples of the basic compound may include a basic inorganic compound such as sodium hydroxide, potassium hydroxide, sodium carbonate, potassium carbonate, sodium silicate, sodium metasilicate, or ammonia; and a basic organic compound such as ethylamine, n-propylamine, monoethanolamine (MEA), diethylamine, di-n-propylamine, diethanolamine, triethylamine, methyldiethylamine, dimethylethanolamine, triethanolamine, tetramethylammonium hydroxide, tetraethylammonium hydroxide, pyrrole, piperidine, 1,8-diazabicyclo [5,4,0]-7 undecene, or 1,5-diazabicyclo [4,3,0]-5 nonane. Among these examples, a basic organic compound is preferable, and monoethanolamine (MEA), ammonia and the like are more preferable.

A content ratio of the basic compound in the agent for forming a protective film according to the present embodiment is not particularly limited as long as the object of the present embodiment is not impaired, but the content of the basic compound with respect to 100 parts by mass of a solid content in the agent for forming a protective film is preferably 0.1 parts by mass or more and 3.0 parts by mass or less. An upper limit of the content of the basic compound with respect to 100 parts by mass of a solid content in the agent for forming a protective film is more preferably 1.5 parts by mass or less, and still more preferably 1.0 part by mass or less. A lower limit of the content of the basic compound with respect to 100 parts by mass of a solid content in the agent for forming a protective film is more preferably 0.3 parts by mass or more.

In addition, a molar ratio of the basic compound to the light-absorbing agent (basic compound/light-absorbing agent) is preferably 1 or more, and more preferably 1 or more and 20 or less. A lower limit of the molar ratio of the basic compound to the light-absorbing agent may be 1.5 or more, 2 or more, or 3 or more. An upper limit of the molar ratio of the basic compound to the light-absorbing agent may be 15 or less, 10 or less, or 5 or less.

### (Dye)

A water-soluble dye is preferably used as a dye. Specific examples of the water-soluble dye may include an azo dye (monoazo and polyazo dyes, a metal complex azo dye, a pyrazolone azo dye, a stilbene azo dye, or a thiazole azo dye), an anthraquinone dye (an anthraquinone derivative or an anthrone derivative), an indigoid dye (an indigoid derivative or a thioindigoid derivative), a phthalocyanine dye, a carbonium dye (a diphenylmethane dye, a triphenylmethane dye, a xanthene dye, or an acridine dye), a quinoneimine dye (an azine dye, an oxazine dye, or a thiazine dye), a methine dye (a cyanine dye or an azomethine dye), a quinoline dye, a nitroso dye, a benzoquinone dye, a naphthoquinone dye, a naphthalimide dye, a perinone dye, and other dyes.

### (Pigment)

A water-soluble pigment is preferably used as a pigment. Specific examples of the water-soluble pigment may include a food additive pigment such as Food Red No. 2, Food Red No. 40, Food Red No. 102, Food Red No. 104, Food Red No. 105, Food Red No. 106, Food Yellow NY, Food Yellow No. 4 Tartrazine, Food Yellow No. 5, Food Yellow No. 5 Sunset Yellow FCF, Food Orange AM, Food Vermilion No. 1, Food Vermilion No. 4, Food Vermilion No. 101, Food Blue No. 1, Food Blue No. 2, Food Green No. 3, Food Melon Color B, or Food Egg Color No. 3. The food additive pigment is preferable from a viewpoint of low environmental load and the like.

### (Plasticizer)

By using a plasticizer, generation of a crack in the protective film can be more effectively suppressed, and flexibility, elasticity, laser workability, and the like of the protective film can be more effectively improved. Specific examples of the plasticizer may include a monosaccharide and a disaccharide.

Specific examples of the monosaccharide may include an aldose (a monosaccharide having a formyl group), a ketose (a monosaccharide having a carbonyl group), and derivatives thereof. Examples of the derivatives may include aldonic acid (a carboxylic acid in which a formyl group at a 1-position of an aldose is converted into a carboxy group), uronic acid (a carboxylic acid in which a hydroxymethyl group at a terminal of a main chain of a monosaccharide is converted into a carboxy group), and aldaric acid (a dicarboxylic acid in which both a formyl group at a 1-position of an aldose and a hydroxymethyl group at a terminal of a main chain are changed to carboxyl groups) .

Specific examples of the aldose may include D-glyceraldehyde, D-erythrose, D-threose, D-ribose, D-arabinose, D-xylose, D-lyxose, D-glucose, D-galactose, D-allose, D-altrose, D-mannose, D-growth, D-idose, and D-talose.

Specific examples of the ketose may include dihydroxyacetone, D-erythrulose, D-xylulose, D-ribulose, D-fructose, D-psicose, D-sorbose, D-tagatose, and D-sedoheptulose.

Specific examples of the derivatives may include gluconic acid, glucuronic acid, glucaric acid, and inositol.

Examples of the disaccharide may include a disaccharide including the monosaccharides described above as monosaccharides. Specific examples of the disaccharide may include maltose, sucrose, lactose, lactulose, trehalose, and cellobiose.

Among the above examples, D-ribose, D-xylose, D-glucose, D-galactose, D-fructose, inositol, and maltose are preferable, and D-ribose, D-glucose, D-galactose, D-fructose, inositol, and maltose are more preferable.

### (Preservative)

It is preferable to use a preservative from a viewpoint of further improving a preservative effect of the agent for forming a protective film according to the present embodiment and further reducing a processing load of a waste liquid after semiconductor wafer cleaning. Examples of the preservative may include benzoic acid, butylparaben, ethylparaben, methylparaben, propylparaben, sodium benzoate, sodium propionate, benzalkonium chloride, benzethonium chloride, benzyl alcohol, cetylpyridinium chloride, chlorobutanol, phenol, phenylethyl alcohol, 2-phenoxyethanol, phenylmercuric nitrate, thimerosal, methacresol, and lauryldimethylamine oxide. These compounds may be used singly or in combination of two or more kinds thereof.

### (Surfactant)

A surfactant is used, for example, for improving defoaming properties at the time of producing an agent for forming a protective film, stability of the agent for forming a protective film, coatability of the agent for forming a protective film, and the like. It is preferable to use a surfactant from a viewpoint of defoaming properties at the time of producing the agent for forming a protective film.

A protective film is formed, for example, by spin-coating an agent for forming a protective film. However, when the protective film is formed, irregularities due to air bubbles may be generated. In order to suppress generation of such irregularities, it is preferable to use an antifoaming agent such as a surfactant.

As the surfactant, a water-soluble surfactant can be preferably used. As the surfactant, any of a nonionic surfactant, a cationic surfactant, an anionic surfactant, and an amphoteric surfactant can be used. The surfactant may be a silicone-based surfactant. A nonionic surfactant is preferable from a viewpoint of cleaning performance.

### (Solvent)

The agent for forming a protective film according to the present embodiment contains a solvent in order to dissolve the above-described solid components. As the solvent, water (for example, pure water, de-ionized water (DIW), ionic water, distilled water, purified water, and the like.), an organic solvent, or both of these can be used. The solvent preferably contains water in terms of less risk such as ignition at the time of use, cost, and the like. Specifically, the solvent is preferably water or an aqueous solution of an organic solvent, and more preferably a combination of water and an organic solvent.

Specific examples of the organic solvent may include, but are not particularly limited to, methyl alcohol, ethyl alcohol, an alkylene glycol, an alkylene glycol monoalkyl ether, and an alkylene glycol monoalkyl ether acetate.

Examples of the alkylene glycol may include ethylene glycol and propylene glycol. Examples of the alkylene glycol monoalkyl ether may include ethylene glycol monomethyl ether, ethylene glycol monoethyl ether, propylene glycol monomethyl ether, and propylene glycol monoethyl ether. Examples of the alkylene glycol monoalkyl ether acetate may include ethylene glycol monomethyl ether acetate, ethylene glycol monoethyl ether acetate, propylene glycol monomethyl ether acetate, and propylene glycol monoethyl ether acetate.

These organic solvents may be used singly or in combination of two or more kinds thereof.

The agent for forming a protective film according to the present embodiment may use water and an organic solvent in combination. As a combination of water and an organic solvent, for example, a mixed solvent of water and an alkylene glycol monoalkyl ether is preferable, and a mixed solvent of water and propylene glycol monomethyl ether is more preferable.

When a mixed solvent in which water and an organic solvent are used in combination is used, a content ratio of the organic solvent in the mixed solvent (the content of the organic solvent with respect to the total of water and the organic solvent; (organic solvent/(water + organic solvent)) is not particularly limited, but an upper limit of the content ratio of the organic solvent in the mixed solvent is preferably less than 50% by mass, more preferably 30% by mass or less, still more preferably 20% by mass or less, and further still more preferably 15% by mass or less from a viewpoint of flammability.

In addition, from the viewpoint of flammability, it is desirable to reduce the content ratio of the organic solvent in the mixed solvent, but according to the present embodiment, when only a water-soluble resin is used as a resin, the content ratio of the organic solvent can be sufficiently reduced. From such a viewpoint, as a preferable aspect that can be achieved by the present embodiment, a lower limit of the content ratio of the organic solvent in the mixed solvent can be preferably reduced to 5% by mass (5% by mass or more), more preferably can be reduced to 3% by mass (3% by mass or more), and still more preferably can be reduced to 0% by mass (0% by mass or more).

When only a water-soluble resin is used as a resin in the present embodiment, even if the content ratio of the organic solvent is reduced to the above range, a solid content in the agent for forming a protective film can be effectively dissolved, which is preferable.

The solvent is preferably selected such that the agent for forming a protective film does not have a flash point at 1 atm. Specifically, by adjusting the content of water in the agent for forming a protective film, a flash point of a protective film and presence or absence of the flash point are adjusted.

An agent for forming a protective film having no flash point can ensure higher safety. For example, the agent for forming a protective film can be placed in a non-explosion-proof environment. Specifically, handling such as storage, transportation, or use of the agent for forming a protective film can be performed in a non-explosion-proof environment. For example, not only the agent for forming a protective film can be introduced into a semiconductor factory, but also the protective film can be formed in a non-explosion-proof environment. Therefore, an agent for forming a protective film having no flash point is industrially very advantageous in that an explosion-proof environment such as a usually expensive explosion-proof facility is unnecessary.

The flash point is obtained by performing measurement with a tag closed system at a liquid temperature of 80°C or lowers and performing measurement with a Cleveland open system at a liquid temperature of higher than 80°C under 1 atm. In the present specification, a case where the flash point cannot be measured even when measurement is performed by the Cleveland opening system is defined as no flash point.

### <Method for producing protective film, and protective film>

According to the present embodiment, a protective film can be obtained by applying the above-described agent for forming a protective film onto a substrate or the like to be protected. Specifically, a method for producing a protective film according to the present embodiment preferably includes a step of applying the above-described agent for forming a protective film onto a substrate to form a protective film. An application method is not particularly limited, but spin coating, spray coating, die coating, roll coating, flow coating, curtain coating, and the like can be adopted depending on the shape, material, and the like of an object to be protected. Furthermore, after the application, post-treatment such as a drying step such as natural drying or hot air drying, or a light irradiation step such as ultraviolet irradiation may be performed.

Usually, when a protective film for a semiconductor wafer is prepared, spin coating or the like is adopted. The spin coating includes, for example, (i) a step of applying an agent for forming a protective film to an application object (a semiconductor wafer or the like) fixed onto a stage of a spin coater (discharge step), (ii) a step of removing an excessive agent for forming a protective film with centrifugal force by rotating the stage to form a thin film (rotation treatment step), and (iii) a step of removing the workpiece from the spin coater and preparing a thin film by natural drying, hot air drying, or the like (drying step). The spin coating is preferable as a protective film for a semiconductor wafer, and furthermore, as a protective film for plasma dicing because it has an advantage of being able to form a film with a small film thickness deviation, an advantage of being excellent in film forming cost and film forming speed because it can be performed even in a non-vacuum state, and the like.

A protective film obtained by the present embodiment contains: a metal salt having a boiling point of 900°C or higher in a case where the metal salt is a metal fluoride; and a first resin having no aromatic ring. Furthermore, the protective film preferably further contains a second resin having an aromatic ring. As the salt (metal salt) of a metal having a boiling point of 900°C or higher in a case where the metal salt is a metal fluoride, the first resin, the second resin, and the like, those described above can be adopted.

A content ratio of the metal salt having a boiling point of 900°C or higher in a case where the metal salt is a metal fluoride in the protective film according to the present embodiment is not particularly limited, but the content ratio of the metal salt in the protective film (metal/protective film) is preferably 0.15% by mass or more from a viewpoint of being able to further increase a selection ratio while having excellent film formation properties. A lower limit of the content ratio is more preferably 1.0% by mass or more, and still more preferably 1.5% by mass or more. An upper limit of the content ratio is preferably 3.5% by mass or less, more preferably 3.0% by mass or less, and still more preferably 2.5% by mass or less.

The metal having a boiling point of 900°C or higher in a case where the metal salt is a metal fluoride preferably contains at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce. As for this metal, a metal having the above-described physical properties and characteristics can be appropriately adopted.

According to the present embodiment, it can be expected to form a protective film having excellent film formation properties and etching resistance over a wide film thickness from a thin film thickness to a thick film thickness. As a preferable aspect thereof, the film thickness of the protective film is preferably 0.1 µm or more and 100 µm or less. A lower limit of the film thickness is more preferably 1 µm or more, and still more preferably 3 µm or more. An upper limit of the film thickness is more preferably 50 µm or less, still more preferably 30 µm or less, further still more preferably 20 µm or less, and further still more preferably 10 µm or less. In this regard, for example, when a protective film is formed by spin coating, it is possible to more effectively form a film having excellent film formation properties and etching resistance for a film thickness in the above range.

### <Method for producing a semiconductor chip>

By using the agent for forming a protective film according to the present embodiment, a semiconductor wafer can be preferably produced by plasma dicing. Typically, the above-described method for producing a semiconductor chip includes cutting a position of a processed groove (a position corresponding to a street position) in a semiconductor wafer. A preferable example of the method for producing a semiconductor chip according to the present embodiment is a method for producing a semiconductor chip by cutting a semiconductor wafer by plasma dicing, the method including:
(1) a step of applying the above-described agent for forming a protective film onto a semiconductor wafer to form a protective film;
(2) a step of irradiating a predetermined position of one or more layers including the protective film on the semiconductor wafer with a laser beam to expose a surface of the semiconductor wafer and form a processed groove having a pattern corresponding to the shape of the semiconductor chip; and
(3) a step of irradiating the semiconductor wafer on which the processed groove is formed with plasma to cut a position of the processed groove of the semiconductor wafer to obtain a semiconductor chip.

Hereinafter, the step of forming a protective film (see step (1)) is also referred to as a "protective film forming step". The step of forming a processed groove (see step (2)) is also referred to as a "processed groove forming step". The step of cutting the position of the processed groove on the semiconductor wafer (see step (3)) is also referred to as a "cutting step".

### (Protective film forming step)

In the protective film forming step, the above-described agent for forming a protective film is applied onto a semiconductor wafer to form a protective film. The agent for forming a protective film is preferably applied by spin coating.

The shape of a processed surface of the semiconductor wafer is not particularly limited as long as desired processing can be performed on the semiconductor wafer. Typically, the processed surface of the semiconductor wafer has a large number of irregularities. A recess is formed in a region corresponding to a street. On a processed surface of the semiconductor wafer, a plurality of regions corresponding to semiconductor chips are partitioned by streets.

The film thickness of the protective film is preferably 0.1 µm or more and 100 µm or less from a viewpoint of easily removing the protective film by washing with water after processing, further improving durability (for example, plasma etching resistance) of the protective film against plasma irradiation when plasma irradiation is performed in the cutting step described later, and the like. A lower limit of the film thickness is more preferably 1 µm or more, and still more preferably 3 µm or more. An upper limit of the film thickness is more preferably 50 µm or less, still more preferably 30 µm or less, further still more preferably 20 µm or less, and further still more preferably 10 µm or less.

Hereinafter, a method for producing a semiconductor chip in which dicing is performed using an agent for forming a protective film on a semiconductor wafer including a plurality of semiconductor chips partitioned by grid-shaped streets will be described as a preferable aspect of the method for producing a semiconductor chip. Note that the shape and size of the semiconductor chip are not particularly limited, and can be appropriately set according to design of the semiconductor chip.

In the semiconductor wafer, a stacked body in which functional films forming an insulating film and a circuit are stacked is disposed on a surface of a semiconductor substrate such as silicon (silicon substrate or the like). In this stacked body, a plurality of semiconductor chips such as ICs and LSIs is formed in a matrix. The semiconductor chips are partitioned by streets formed in a grid shape. As the insulating film, for example, a low dielectric constant insulator film (low-k film) including a SiO₂ film, an inorganic film such as SiOF or BSG (SiOB), or an organic film which is a polymer film such as a polyimide-based film or a parylene-based film can be adopted.

An agent for forming a protective film is applied onto a surface of the stacked body on the semiconductor substrate to form a protective film. In the protective film forming step, for example, the agent for forming a protective film is applied to a surface of the semiconductor wafer by a spin coater. Note that a method for applying the agent for forming a protective film is not particularly limited as long as a protective film having a desired film thickness can be formed, and the above-described various application methods can be adopted.

Subsequently, the liquid agent for forming a protective film covering the surface is dried as necessary. As a result, a protective film is formed on the surface of the semiconductor wafer. As described above, the protective film according to the present embodiment is a protective film suppressing generation of a crack and having no cracks or few cracks, and has excellent plasma etching resistance. Furthermore, a protective film also suppressing stickiness can be formed.

After the protective film is formed on the front surface of the semiconductor wafer in this manner, a protective tape may be attached to a back surface of the semiconductor wafer as necessary.

### (Processed groove forming step)

In the processed groove forming step, a predetermined position of one or more layers including the protective film on the semiconductor wafer is irradiated with a laser beam to expose a surface of the semiconductor substrate, and a processed groove having a pattern corresponding to the shape of the semiconductor chip is formed. The agent for forming a protective film and the protective film according to the present embodiment are not only excellent in film formation properties and plasma etching resistance, but are also expected to improve straightness of a processed groove (straightness of a sidewall of the protective film constituting the processed groove) and rectangularity of a cross section of the processed groove (rectangularity of a cross section of the protective film constituting the processed groove). When workability is excellent, cutting by plasma etching can be accurately performed without being deviated from a desired position, and therefore cutting can be performed with higher positional accuracy.

Specifically, a surface (street) on the semiconductor wafer is irradiated with a laser beam through the protective film. The laser is preferably an ultraviolet laser having a wavelength of 100 nm or more and 400 nm or less from a viewpoint of intensity. In addition, a YVO4 laser or a YAG laser having a wavelength of 266 nm or 355 nm is preferable.

The laser light irradiation in the processed groove forming step can be performed, for example, under the following processing conditions. Note that a focused spot diameter can be appropriately selected in consideration of the width of the processed groove.
Light source of laser beam: YVO4 laser or YAG laser
Wavelength: 355 nm
Repeat frequency: 50 kHz or more and 100 kHz or less
Output: 0.1 W or more and 4.0 W or less
Processing feed speed: 1 mm/sec or more and 800 mm/sec or less

By performing the above-described processed groove forming step, a processed groove is formed along the street in the stacked body including the street in the semiconductor wafer. As described above, the protective film according to the present embodiment can suppress generation of a crack and has excellent durability (for example, plasma etching resistance). As a result, by irradiating the protective film with a laser beam, a groove (processed groove) excellent in straightness and cross-sectional rectangularity can be formed in the protective film.

After the irradiation with a laser beam is performed along the predetermined street as described above, the semiconductor wafer held on a chuck table is index-moved by a street interval, and the irradiation with the laser beam is performed again.

In this way, after the irradiation with a laser beam and the index-moving are performed for all the streets extending in a predetermined direction, the semiconductor wafer held on the chuck table is rotated by 90 degrees, and the irradiation with a laser beam and the index-moving are performed in a similar manner to the above along each street extending at a right angle to the predetermined direction. In this way, processed grooves can be formed along all the streets formed in the stacked body on the semiconductor wafer.

### (Cutting step)

In the cutting step, the semiconductor wafer on which the processed groove is formed is irradiated with plasma, and the position of the processed groove of the semiconductor wafer is cut to obtain a semiconductor chip. Specifically, the semiconductor wafer having a processed groove at a position corresponding to the position of the street is cut by plasma etching. The protective film according to the present embodiment is preferable as a protective film for plasma etching, and therefore can exhibit its advantage in a method for producing a semiconductor wafer in which a cutting method by plasma etching is performed.

When plasma is emitted, the plasma is emitted to a part or the whole of a surface of the semiconductor wafer including the protective film such that a surface of the processed groove is exposed to the plasma. Hereinafter, an example of the cutting method by plasma irradiation will be described.

First, the semiconductor wafer including the protective film and the processed groove is irradiated with plasma. By the irradiation, the position of the processed groove in the semiconductor wafer is cut. Specifically, in the semiconductor wafer covered with the protective film, after the processed groove is formed as described above, plasma irradiation is performed on the protective film and a surface of the semiconductor substrate exposed from the processed groove. As a result, the semiconductor wafer is cut according to the shape of the semiconductor chip, and the semiconductor wafer is divided into individual semiconductor chips.

A plasma irradiation condition is not particularly limited as long as the semiconductor wafer can be favorably cut at the position of the processed groove. As the plasma irradiation condition, a condition suitable for plasma etching on a semiconductor substrate can be selected in consideration of a material of the semiconductor wafer, a plasma kind, and the like.

A gas (etching gas) used for plasma generation in plasma irradiation can be appropriately selected according to a material of the semiconductor wafer or the like, and for example, an SF₆ gas can be used. In addition, it is preferable to cut the semiconductor wafer by alternately performing sidewall protection by supplying a fluorine-based gas such as a C₄F₆ gas or a C₄F₈ gas and etching of the semiconductor wafer by plasma irradiation by adopting a Bosch process. The Bosch process has an advantage that etching at a high aspect ratio is possible and cutting of a semiconductor wafer is easy even when the semiconductor wafer is thick.

Furthermore, in the Bosch process, since the fluorine-based gas described above is used as an etching gas under vacuum or reduced pressure, fluorine radicals are generated in the system. However, since the protective film according to the present embodiment contains a metal having a boiling point of 900°C or higher in a case where the metal salt is a metal fluoride, it is possible to effectively suppress volatilization of fluorine radicals in the system. As a result, there is also an advantage that defects such as unnecessary contamination, etching, or damage of the wafer by the volatilized fluorine radicals can be effectively suppressed.

The protective film according to the present embodiment has at least excellent plasma etching resistance. By using such a protective film, it is also expected that a processed groove having excellent straightness and cross-sectional rectangularity can be formed. As a result, it will also be possible to obtain a semiconductor chip that can be accurately cut at a desired position by plasma irradiation and has excellent straightness.

In addition, the protective film according to the present embodiment at least suppresses generation of a crack and has excellent film formation properties. Therefore, it is possible to sufficiently protect a position other than a cutting position, and it is possible to effectively prevent cutting of an undesired position (position other than the processed groove) by plasma irradiation or the like. Contamination, damage, and the like of the semiconductor substrate due to a gas such as a fluorine-based gas used in plasma irradiation can be also effectively suppressed.

Subsequently, the protective film covering a surface of the semiconductor chip is removed. As described above, when the protective film contains a water-soluble resin, the protective film can be efficiently washed away with water.

An example of the method for producing a semiconductor chip by processing a semiconductor wafer has been described above. The method for producing a semiconductor chip according to the present embodiment can be applied to various methods for producing a semiconductor chip as long as the methods include forming a protective film on a surface of a semiconductor wafer, forming a processed groove at a position corresponding to a street on a surface including the protective film of the semiconductor wafer, and cutting the processed groove by plasma irradiation.

In recent years, the street has been narrowed in order to increase the number of chips taken out (the number of chips) per wafer. Furthermore, for a small chip device that is in demand for a mobile device and IoT, further improvement in quality and productivity is desired. In such a semiconductor producing process of a device requiring high quality and high productivity, the producing method according to the present embodiment is particularly preferable as a method capable of solving the above-described problem of plasma dicing.

### Examples

The present invention will be described in more detail with reference to the following Examples and Comparative Examples, but the present invention is not limited to the following Examples at all. Note that, in the following, unless otherwise specified, the quantity is based on mass, and the experiment was performed under conditions of 25°C and atmospheric pressure.

### <Components used>

Resins, metal salts, additives, and the like used in the present Examples will be described.

### (1) First water-soluble resin (non-aromatic resin)

### • Resin (1Aa):

Hydroxypropyl cellulose (a resin having a repeating unit represented by the following formula (1Aa), weight average molecular weight: 25,000, manufactured by Nippon Soda Co., Ltd., trade name "HPC-SSL", HPC-SSL)

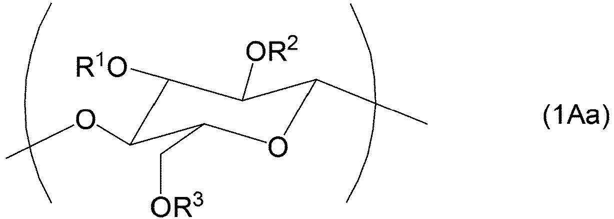

(In the formula, R¹, R², and R³ are each independently a substituent represented by -H or - CH₂CH(OH)CH₃, and at least one of all R¹s, R²s, and R³s included in the resin is -CH₂CH(OH)CH₃.)

### • Resin (1Bb):

Polyvinyl alcohol (formula (1b): a resin having a repeating unit represented by the following formula (1b-1) and a repeating unit represented by formula (1b-2), estimated polymerization degree: 500, manufactured by Kuraray Co., Ltd., trade name: "Kuraray Poval PVA-505C", PVA-505C)

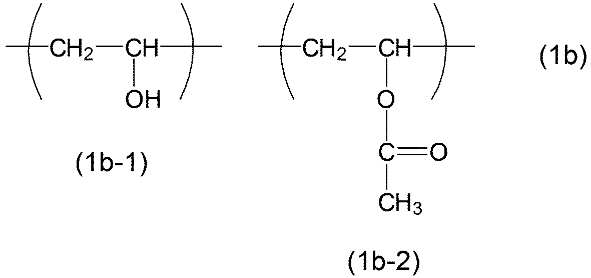

### • Resin (1Cc):

Poly-N-vinylacetamide (a resin having a repeating unit represented by the following formula (1c), weight average molecular weight: 300,000, manufactured by Showa Denko K.K., trade name: "PNVA GE191-104", PNVA 104)

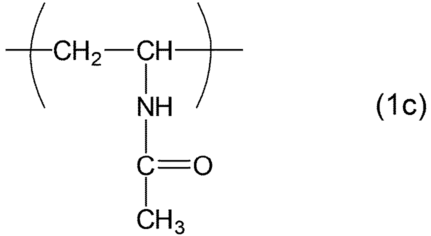

### • Resin (1Dd):

Polyvinylpyrrolidone (a resin having a repeating unit represented by the following formula (1d), weight average molecular weight: 1,200,000, manufactured by DKS Co. Ltd., trade name: "PITZCOL K-90", PVP K-90)

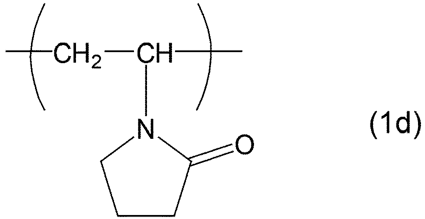

### (2) Second water-soluble resin (aromatic resin)

### • Resin (2Aa):

A resin having a repeating unit represented by formula (2a-1) and a repeating unit represented by formula (2a-2) (see formula (2Aa), weight average molecular weight: 22,000) was prepared and used.

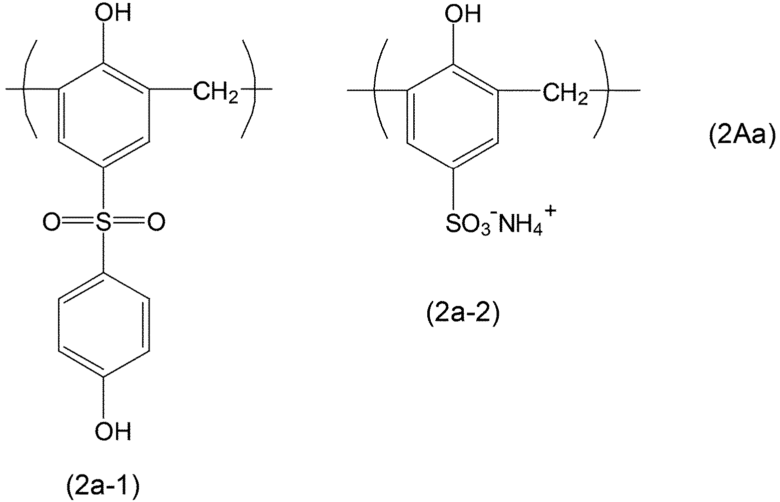

The resin (2Aa) was obtained by treating a resin (2Aaa) as a raw material (see the following formula (2Aaa), a resin (2Aaa) having a repeating unit represented by formula (2aa-1) and a repeating unit represented by formula (2aa-2) in a molar ratio of 4 : 1, that is, a resin (2Aaa) in which a molar ratio of the repeating unit represented by formula (2aa-1) to the repeating unit represented by formula (2aa-2) (formula (2a-1)/(formula (2a-2)) is 4, weight average molecular weight: 22,000, trade name: "WSR-SP82" manufactured by Konishi Chemical Ind. Co., Ltd.) with hydrochloric acid and then diluting this resin (2Aaa) with an ammonia aqueous solution (WSR-SP82 (NH₄)).

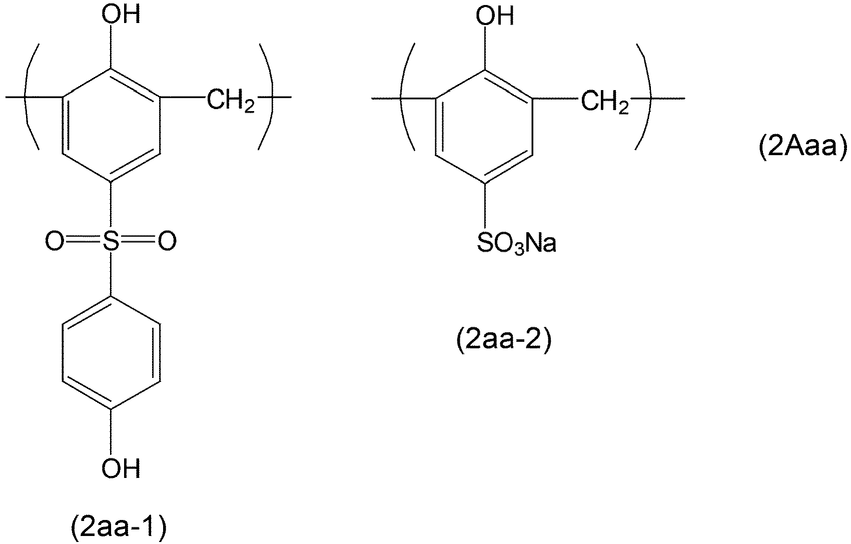

### • Resin (2Bb):

A resin having a repeating unit represented by formula (2b-1) and a repeating unit represented by formula (2b-2) (see formula (2Bb), weight average molecular weight: 10,000) was prepared and used.

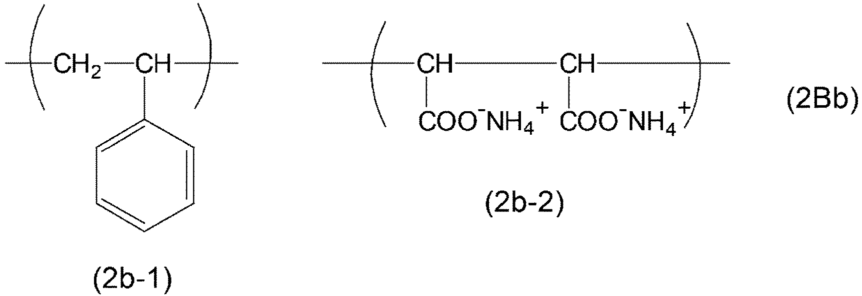

The resin (2Bb) was obtained by diluting a styrenemaleic anhydride copolymer as a raw material (see the following formula (2Bbb), a resin (2Bbb) having a repeating unit represented by formula (2bb-1) and a repeating unit represented by formula (2bb-2) in a molar ratio of 3 : 1, that is, a resin (2Bbb) in which a molar ratio of the repeating unit represented by formula (2bb-1) to the repeating unit represented by formula (2bb-2) is 3, a weight average molecular weight: 10,000, trade name: "XIRAN 3000P" manufactured by POLYSCOPE Corporation) with an ammonia aqueous solution (ammonia concentration: 5% by mass) in a mixed solvent of de-ionized water (DIW) and propylene glycol monomethyl ether (PGME) (mass ratio of DIW/PGME= 85/15) so as to have a resin solid content concentration of 14% by mass to ring-open maleic anhydride (XIRAN-3000P (NH₄)).

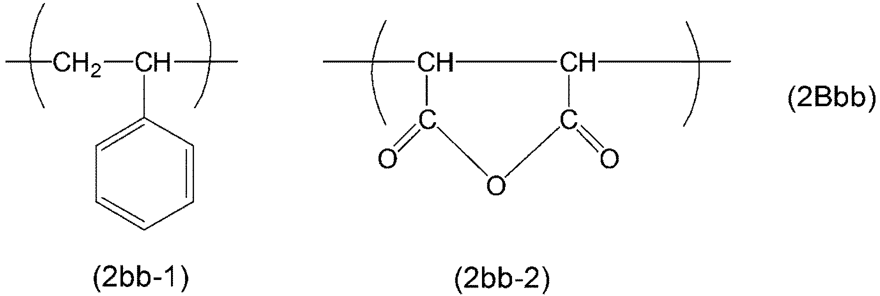

### • Resin (2Cc):

Polystyrenesulfonic acid (a resin having a repeating unit represented by the following formula (2c), weight average molecular weight: 22,000, manufactured by Tosoh Finechem Corporation, trade name "PS-1H", PS-1H)

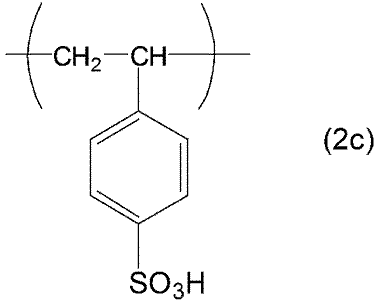

Note that 0.5 g or more of each of the first water-soluble resin and the second water-soluble resin described above was dissolved in 100 g of water at 25°C.

### (3) Metal salt

• Sodium sulfate
• Sodium nitrate
• Calcium nitrate tetrahydrate
• Zirconium nitrate dihydrate
• Aluminum nitrate nonahydrate

Note that the number of parts by mass of a metal salt hydrate described in each Table is the number of parts by mass of only a metal salt excluding water of a hydrate.

### (4) Additive

• Light-absorbing agent: 2-(4-diethylamino-2-hydroxybenzoyl) benzoic acid (DHBA)
• Basic compound: monoethanolamine (MEA)

### <Example 1>

First, components presented in Table 2 (99.54 parts by mass of a first resin (a cellulose derivative obtained by causing propylene oxide to react with cellulose, manufactured by Nippon Soda Co., Ltd., trade name: "NISSO HPC-SSL") and 0.46 parts by mass of sodium sulfate) were added to a mixed solvent of de-ionized water (DIW) and propylene glycol monomethyl ether (PGME) (mass ratio of DIW/PGME= 85/15, content ratio of organic solvent in the mixed solvent: 15% by mass), and the mixture was diluted so as to have a solid content concentration presented in Table 2 (target solid content concentration, solvent mass ratio = DIW/PGME = 85/15). Then, the mixture was stirred until the inside of the system became uniform to obtain an agent for forming a protective film. The agent for forming a protective film contains 99.54 parts by mass of the first resin (non-aromatic resin) and 0.46 parts by mass of the metal salt as solid contents, and has a solid content concentration of 20% by mass.

Next, the agent for forming a protective film was applied to a surface of a silicon substrate using a spin coater, and then naturally dried at room temperature for 15 minutes to form a protective film having a film thickness of 5 µm.

Subsequently, the surface of the Si substrate on the protective film side was linearly irradiated with plasma to perform etching for forming a division groove. Note that the plasma irradiation was performed by a Bosch process under the following laser irradiation conditions.

### • Bosch process:

A sidewall protection step by supplying a fluorine gas (C₄F₈ gas) (step of converting a fluorine gas into plasma and depositing a CF-based protective film on a silicon substrate) and an etching step (an etching step of removing a film on a bottom surface by an ion assist effect, causing Si of the silicon substrate exposed by SF₆ plasma irradiation to react with F atoms generated by plasmatization, and removing silicon tetrafluoride (SiF₄)) were alternately repeated.

### • Laser irradiation conditions:

Wavelength: 355 nm
Frequency: 100 kHz
Output: 0.1 W
Defocus: -0.1 mm
Feeding speed: 100 mm/s
Pass: 2

### (Measurement of solid content concentration)

First, an aluminum case was precisely weighed (tare A (g)). Next, 1 g of the agent for forming a protective film was precisely weighed and put in the aluminum case (weighing value: B (g)). This sample was dried at 140°C for 120 minutes. After being dried, the sample was cooled to room temperature and then precisely weighed (weighing value: C (g)). Then, a solid content concentration was calculated on the basis of the following formula. Note that an electronic balance that can be weighed to the order of 0.0001 g was used as an electronic balance used for precise weighing. Solid content concentration (% by mass) = (C - A)/(B - A) ×100
A: mass of tare (g)
B: total mass of sample and tare (g)
**C:** total mass of sample and tare after drying (g)

### (Measurement of metal content)

The metal content in the agent for forming a protective film was quantified by inductively coupled plasma emission spectroscopy. Note that the measurement was performed by a calibration curve method, a calibration curve was prepared at a concentration of level 4 or higher, and the measurement was performed at a correlation coefficient of 0.99 or more in the calibration curve. As a metal reagent used in the calibration curve method, a mixed solution of 1 part by mass of a multi-element mixed standard solution "XSTC-622" (metal element concentration: 10 mg/L) manufactured by SPEX and 99 parts by mass of dimethylacetamide (DMAC) (metal element concentration: 100 ppb by mass) was used.

### (Evaluation of film formation properties (crack of protective film))

The agent for forming a protective film was applied onto a silicon substrate by a spin coating method under the conditions described above to obtain a protective film having a film thickness of 5 µm. The obtained protective film was dried under reduced pressure to a measurement environment (6.0 Pa) of a scanning electron microscope (SEM). Then, the coating film after drying under reduced pressure was observed with an optical microscope at a magnification of 10 times, and film formation properties (presence or absence of a crack in the protective film) was evaluated on the basis of the following criteria. Note that, when a crack was generated (in a case of "B"), a selection ratio was not measured ("-" in each Table).
- "A": Generation of a crack was not confirmed.
- "B": Generation of a crack was confirmed.

Note that, in Examples 1 to 17, when a surface of the protective film was touched with a finger to confirm presence or absence of stickiness (tackiness), it was confirmed that there was no stickiness in all Examples.

### (Measurement of selection ratio)

A selection ratio was determined by calculation on the basis of the following formula. Selection ratio = film loss amount of silicon substrate/film loss amount of protective film
- Film loss amount of silicon substrate = film thickness of silicon substrate before irradiation - film thickness of silicon substrate after irradiation
- Film loss amount of protective film = film thickness of protective film before irradiation - film thickness of protective film after irradiation

### <Examples 2 to 11>

An agent for forming a protective film was prepared according to Example 1 except that the components of the agent for forming a protective film were changed to the components presented in Table 2. Note that the agent for forming a protective film of Example 7 contains, as solid contents, 2.5 parts by mass of 2-(4-diethylamino-2-hydroxybenzoyl) benzoic acid (DHBA) and 0.7 parts by mass of monoethanolamine (MEA) in addition to 91.26 parts by mass of a first resin and 5.54 parts by mass of a metal salt, and has a solid content concentration of 20% by mass. In the agent for forming a protective film of Example 7, a molar ratio of MEA/DHBA was 1.1 (= (0.7 ÷ 61.08)/(2.5 ÷ 246.22) .

### <Examples 12 to 17>

An agent for forming a protective film was prepared according to Example 1 except that the components of the agent for forming a protective film were changed to the components presented in Table 3. For example, the agent for forming a protective film of Example 12 contains, as solid contents, 85.01 parts by mass of a first resin (non-aromatic resin), 9.45 parts by mass of a second resin (aromatic resin), and 5.54 parts by mass of a metal salt, and has a solid content concentration of 18% by mass.

Note that, in Examples 1 to 17, straightness was also evaluated on the basis of the following criteria. At least "B" or higher ("B" or "A") was evaluated as a practically acceptable level. As a result, it was confirmed that all Examples were at least "B" or higher ("B" or "A").
- "A": A cross section of a protective film (a sidewall of a processed groove) was flat, and a straight groove (trench) without wobble was formed.
- "B": A cross section of a protective film was relatively flat, and a relatively straight groove (trench) with slight wobble was formed.
- "C": A cross section of a protective film was not flat, and a groove (trench) with large wobble was formed.
- "D": Processing defect (A pattern became soft by heat of a laser, a shape could not be maintained, and a processed groove could not be formed.)

### <Comparative Examples 1 to 12>

An agent for forming a protective film was prepared according to Example 1 except that the components of the agent for forming a protective film were changed to the components presented in Table 4. For example, an agent for forming a protective film of Comparative Example 1 contains, as a solid content, only 100 parts by mass of a first resin (non-aromatic resin) and has a solid content concentration of 18% by mass.

Formulations and evaluation results of Examples 1 to 11 are presented in Table 2, formulations and evaluation results of Examples 12 to 17 are presented in Table 3, and formulations and evaluation results of Comparative Examples 1 to 12 are presented in Table 4.

**[Table 2]**

| | | | | Example | | | | | | | | | | |
|---|---|---|---|---|---|---|---|---|---|---|---|---|---|---|
| | | | | 1 | 2 | 3 | 4 | 5 | 6 | 7 | 8 | 9 | 10 | 11 |
| | Metal salt (parts by mass) | | Sodium sulfate | 0.46 | | | | | | | | | | |
| | | | Sodium nitrate | | 0.55 | | | | 5.54 | 5.54 | 5.54 | 5.54 | 5.54 | 9.24 |
| | | | Calcium nitrate | | | 0.89 | | | | | | | | |
| | | | Zirconium nitrate | | | | 0.44 | | | | | | | |
| | | | Aluminum nitrate | | | | | 2.08 | | | | | | |
| | Water-soluble resin (parts by mass) | First | 1Aa (HPC-SSL) | 99.54 | 99.45 | 99.11 | 99.56 | 97.92 | 94.46 | 91.26 | | | | 90.76 |
| | | | 1Bb (PVA-505C) | | | | | | | | 94.46 | | | |
| Formulation | | | 1Cc (PNVA 104) | | | | | | | | | 94.46 | | |
| | | | 1Dd (PVP K-90) | | | | | | | | | | 94.46 | |
| | | Second | 2Aa (WSR-SP82 (NH₄)) | | | | | | | | | | | |
| | | | 2Bb (XIRAN 3000P (NH₄)) | | | | | | | | | | | |
| | | | 2Cc (PS-1H) | | | | | | | | | | | |
| | | Total of resins | | 99.54 | 99.45 | 99.11 | 99.56 | 97.92 | 94.46 | 91.26 | 94.46 | 94.46 | 94.46 | 90.76 |
| | Additive (parts by mass) | | DHBA | | | | | | | 2.5 | | | | |
| | | | MEA | | | | | | | 0.7 | | | | |
| | Solid content concentration (% by mass) | | | 20 | 20 | 20 | 20 | 20 | 20 | 20 | 20 | 85 | 13 | 20 |
| | Metal content ratio (% by mass) | | | 0.15 | 0.15 | 0.15 | 0.15 | 0.15 | 1.5 | 1.5 | 1.5 | 1.5 | 1.5 | 2.5 |
| Evaluation | Film formation properties | | | A | A | A | A | A | A | A | A | A | A | A |
| | Selection ratio | | | 180 | 160 | 160 | 160 | 180 | 200 | 240 | 270 | 270 | 430 | 290 |

**[Table 3]**

| | | | | Example | | | | | |
|---|---|---|---|---|---|---|---|---|---|
| | | | | 12 | 13 | 14 | 15 | 16 | 17 |
| | Metal salt (parts by mass) | | Sodium sulfate | | | | | | |
| | | | Sodium nitrate | 5.54 | | 5.54 | 5.54 | 0.55 | 5.54 |
| | | | Calcium nitrate | | 8.86 | | | | |
| | | | Zirconium nitrate | | | | | | |
| | | | Aluminum nitrate | | | | | | |
| | Water-soluble resin (parts by mass) | First | 1Aa (HPC-SSL) | 85.01 | 82.03 | | | 89.50 | 85.01 |
| | | | 1Bb (PVA-505C) | | | 85.01 | | | |
| | | | 1Cc (PNVA 104) | | | | 85.01 | | |
| Formulation | | | 1Dd (PVP K-90) | | | | | | |
| | | Second | 2Aa (WSR-SP82 (NH₄)) | 9.45 | 8.86 | 9.45 | 9.45 | | |
| | | | 2Bb (XIRAN 3000P (NH₄)) | | | | | 9.95 | |
| | | | 2Cc (PS-1H) | | | | | | 9.45 |
| | | Total of resins | | 94.46 | 90.89 | 94.46 | 94.46 | 99.45 | 94.46 |
| | Additive (parts by mass) | | DHBA | | | | | | |
| | | | MEA | | | | | | |
| | Solid content concentration (% by mass) | | | 18 | 18 | 10 | 35 | 20 | 20 |
| | Metal content ratio (% by mass) | | | 1.5 | 1.5 | 1.5 | 1.5 | 0.15 | 1.5 |
| Evaluation | Film formation properties | | | A | A | A | A | A | A |
| | Selection ratio | | | 270 | 240 | 280 | 440 | 170 | 400 |

**[Table 4]**

| | | | | Comparative Example | | | | | | | | | | | |
|---|---|---|---|---|---|---|---|---|---|---|---|---|---|---|---|
| | | | | 1 | 2 | 3 | 4 | 5 | 6 | 7 | 8 | 9 | 10 | 11 | 12 |
| | Metal salt (parts by mass) | | Sodium sulfate | | | | | | | | | | | | |
| | | | Sodium nitrate | | | | | | | | | | | | |
| | | | Calcium nitrate | | | | | | | | | | | | |
| | | | Zirconium nitrate | | | | | | | | | | | | |
| | | | Aluminum nitrate | | | | | | | | | | | | |
| | Water-soluble resin (parts by mass) | First | 1Aa (HPC-SSL) | 100 | | | | | | | 90 | 90 | 90 | | |
| | | | 1Bb (PVA-505C) | | 100 | | | | | | | | | 90 | |
| | | | 1Cc (PNVA 104) | | | 100 | | | | | | | | | 90 |
| Formulation | | | 1Dd (PVP K-90) | | | | 100 | | | | | | | | |
| | | Second | 2Aa (WSR-SP82 (NH₄)) | | | | | 100 | | | 10 | | | 10 | 10 |
| | | | 2Bb (XIRAN 3000P (NH₄)) | | | | | | 100 | | | 10 | | | |
| | | | 2Cc (PS-1H) | | | | | | | 100 | | | 10 | | |
| | | Total of resins | | 100 | 100 | 100 | 100 | 100 | 100 | 100 | 100 | 100 | 100 | 100 | 100 |
| | Additive (parts by mass) | | DHBA | | | | | | | | | | | | |
| | | | MEA | | | | | | | | | | | | |
| | Solid content concentration (% by mass) | | | 18 | 18 | 85 | 10 | 25 | 15 | 33 | 15 | 20 | 20 | 13 | 35 |
| | Metal content ratio (% by mass) | | | 0 | 0 | 0 | 0 | 0 | 0 | 0 | 0 | 0 | 0 | 0 | 0 |
| Evaluation | Film formation properties | | | A | A | A | A | B | B | B | A | A | A | A | A |
| | Selection ratio | | | 120 | 130 | 120 | 150 | - | - | - | 150 | 150 | 150 | 150 | 150 |

From the above, it has been at least confirmed that each of the agents for forming a protective film according to the present Examples can prepare a protective film having excellent film formation properties and a high selection ratio.

The present application is based on Japanese Patent Application (Japanese Patent Application No. 2022-208225) filed with the Japan Patent Office on December 26, 2022, the contents of which are incorporated herein by reference.

## Claims

1. An agent for forming a protective film, the agent comprising:
a metal salt having a boiling point of 900°C or higher in a case where the metal salt is a metal fluoride;
a first resin having no aromatic ring; and
a solvent.

2. The agent for forming a protective film according to claim 1, further comprising
a second resin having an aromatic ring.

3. The agent for forming a protective film according to claim 1 or 2, wherein
a content ratio of the metal in the metal salt is 0.15% by mass or more in a total amount of components obtained by removing the solvent from the agent for forming a protective film.

4. The agent for forming a protective film according to claim 1 or 2, wherein
the metal of the metal salt contains at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce.

5. The agent for forming a protective film according to claim 1 or 2, wherein
the metal salt contains at least one selected from the group consisting of a sulfate, a nitrate, a nitrite, and hydrates of these salts.

6. The agent for forming a protective film according to claim 1 or 2, wherein
the first resin contains at least one selected from the group consisting of a cellulose-based resin and a vinyl-based resin.

7. The agent for forming a protective film according to claim 1 or 2, wherein
the first resin comprises at least one selected from the group consisting of a resin (1A) comprising a repeating unit represented by the following formula (1a), a resin (1B) comprising a repeating unit represented by the following formula (1b-1) and a repeating unit represented by the following formula (1b-2), a resin (1C) comprising a repeating unit represented by the following formula (1c), and a resin (1D) comprising a repeating unit represented by the following formula (1d): 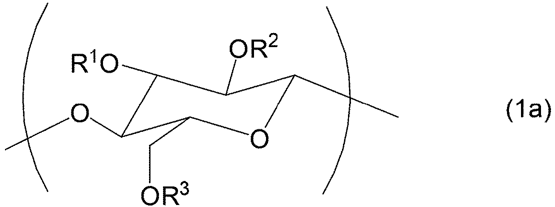
(in the formula, R¹, R², and R³ are each independently a substituent represented by -H, -CH₃, - CH₂CH₃, or -CH₂CH(OH)CH₃, and at least one of all R¹s, R²s, and R³s is a substituent other than -H).

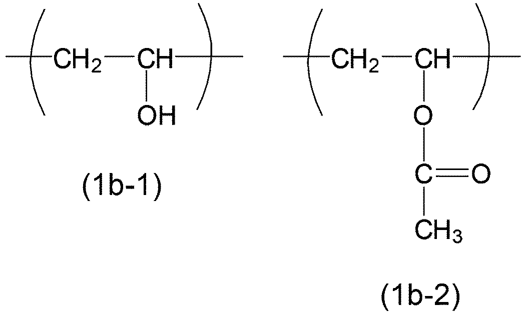

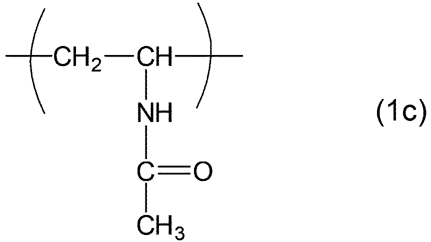

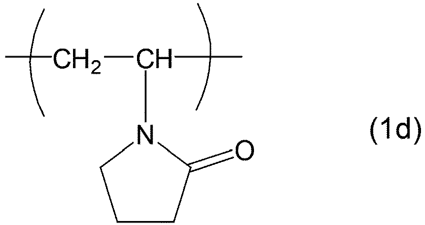

8. The agent for forming a protective film according to claim 2, wherein
the second resin comprises at least one selected from the group consisting of a resin (2A) comprising a repeating unit represented by the following formula (2a-1) and a repeating unit represented by the following formula (2a-2), a resin (2B) comprising a repeating unit represented by the following formula (2b-1) and a repeating unit represented by the following formula (2b-2), and a resin (2C) comprising a repeating unit represented by the following formula (2c): 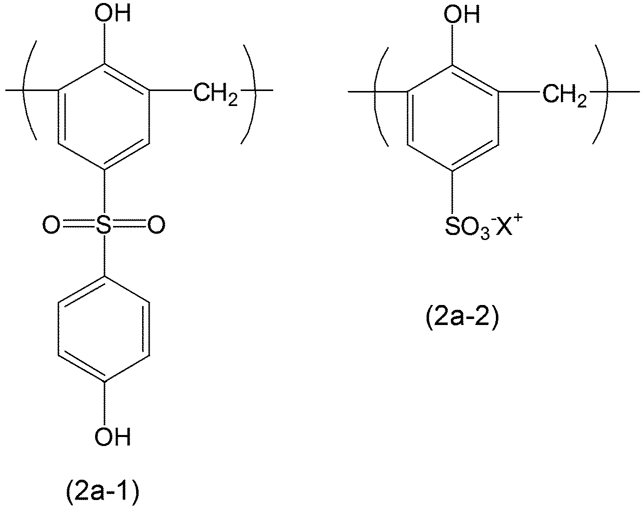
(in the formula, X⁺ is an alkali metal cation, a proton, or N⁺R⁴₄, and R⁴ is a hydrogen atom, an alkyl group, or a hydroxyalkyl group), and 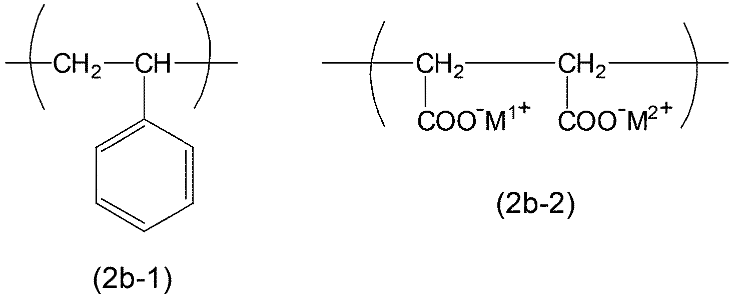
(in the formula, M¹⁺ and M²⁺ are each independently an alkali metal cation, a proton, or N⁺R⁵₄, and R⁵ is a hydrogen atom, an alkyl group, or a hydroxyalkyl group).

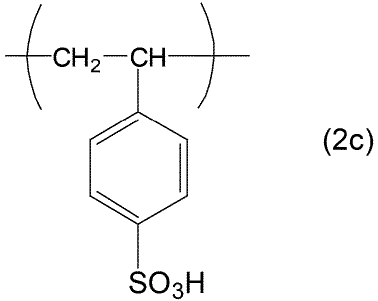

9. A protective film comprising:
a metal salt having a boiling point of 900°C or higher in a case where the metal salt is a metal fluoride; and
a first resin having no aromatic ring.

10. The protective film according to claim 9, further comprising
a second resin having an aromatic ring.

11. The protective film according to claim 9 or 10, wherein
a content ratio of the metal in the metal salt is 0.15% by mass or more in the protective film.

12. The protective film according to claim 9 or 10, wherein
a metal of the metal salt comprises at least one selected from the group consisting of Li, Be, Na, Mg, Al, K, Ca, Mn, Fe, Co, Ni, Cu, Zn, Ga, Rb, Sr, Y, Zr, Ag, Cd, In, Cs, Ba, La, and Ce.

13. The protective film according to claim 9 or 10, having
a film thickness of 0.1 µm or more and 100 µm or less.

14. A method for producing a protective film, the method comprising
a step of applying the agent for forming a protective film according to claim 1 or 2 onto a substrate to form a protective film.

15. A method for producing a semiconductor chip by cutting a semiconductor wafer by plasma dicing, the method comprising:
a step of applying the agent for forming a protective film according to claim 1 or 2 onto a semiconductor wafer to form a protective film;
a step of irradiating a predetermined position of one or more layers including the protective film on the semiconductor wafer with a laser beam to expose a surface of the semiconductor wafer and form a processed groove having a pattern corresponding to a shape of the semiconductor chip; and
a step of irradiating the semiconductor wafer on which the processed groove is formed with plasma to cut a position of the processed groove of the semiconductor wafer to obtain a semiconductor chip.
